# EUROPEAN PATENT SPECIFICATION

(11) **EP 1 848 786 B1**
(45) Date of publication and mention of the grant of the patent: **02.02.2011**
(21) Application number: 06709679.2
(22) Date of filing: 09.02.2006
(51) Int. Cl.: C09K 11/06, H05B 33/14

(54) **ELECTROLUMINESCENT MATERIALS AND DEVICES**
ELEKTROLUMINESZIERENDE STOFFE UND VORRICHTUNGEN
MATERIAUX ET DISPOSITIFS ELECTROLUMINESCENTS

(30) Priority: 18.02.2005 GB 0503393
(43) Date of publication of application: 31.10.2007
(73) Proprietor: Merck Patent GmbH, 64293 Darmstadt (DE)
(72) Inventor: KATHIRGAMANATHAN, Poopathy, North Harrow HA2 7NN (GB); GANESHAMURUGAN, Subramaniam, London N15 4BB, (GB); KUMARAVERL, Muttulingam, Ealing, London W5 1RY (GB); PARTHEEPAN, Arumugam, IIford IG6 1DA (GB); PARAMASWARA, Gnanamoly, Totteridge, London N20 8EB, (GB)
(74) Representative: Seemann, Joachim
(86) International application number: PCT/GB2006/000441
(87) International publication number: WO 2006/087521

(56) References cited:
- WO-A-03/046107
- WO-A-2004/008554
- WO-A-2004/084325
- US-A1- 2001 019 782
- PATENT ABSTRACTS OF JAPAN vol. 2003, no. 11, 5 November 2003 (2003-11-05) & JP 2003 192691 A (MITSUBISHI CHEMICALS CORP), 9 July 2003 (2003-07-09)

## Description

The present invention relates to electroluminescent materials and to electroluminescent devices.

Materials that emit light when an electric current is passed through them are well known and used in a wide range of display applications. Devices which are based on inorganic semiconductor systems are widely used. However these suffer from the disadvantages of high energy consumption, high cost of manufacture, low quantum efficiency and the inability to make flat panel displays. Organic polymers have been proposed as useful in electroluminescent devices, but it is not possible to obtain pure colours; they are expensive to make and have a relatively low efficiency. Another electroluminescent compound which has been proposed is aluminium quinolate, but it requires dopants to be used to obtain a range of colours and has a relatively low efficiency.

Patent application WO 03/046107 discloses lithium quinolate as a host material for organometallic electroluminescent materials to form an electroluminescent layer in an electroluminescent device.

Patent application WO98/58037 describes a range of transition metal and lanthanide complexes which can be used in electroluminescent devices which have improved properties and give better results. Patent Applications PCT/GB98/01773, PCT/GB99/03619, PCT/GB99/04030, PCT/GB99/04024, PCT/GB99/04028 and PCT/GB00/00268 describe electroluminescent complexes, structures and devices using rare earth chelates. US Patent 5128587 discloses an electroluminescent device which consists of an organometallic complex of rare earth elements of the lanthanide series sandwiched between a transparent electrode of high work function and a second electrode of low work function, with a hole conducting layer interposed between the electroluminescent layer and the transparent high work function electrode, and an electron conducting layer interposed between the electroluminescent layer and the electron injecting low work function anode. The hole conducting layer and the electron conducting layer are required to improve the working and the efficiency of the device. The hole transporting layer serves to transport holes and to block the electrons, thus preventing electrons from moving into the electrode without recombining with holes. The recombination of carriers therefore mainly takes place in the emitter layer.

In order to enhance the performance of electroluminescent organo metallic complexes the electroluminescent organo metallic complex can be mixed with a host material and we have now devised an improved electroluminescent material using a metal quinolate as the host material.

According to the invention there is provided an electroluminescent composition which comprises a mixture of a substituted or unsubstituted metal quinolate and an electroluminescent organo metallic complex.

The invention also provides an electroluminescent device which comprises (i) a first electrode, (ii) a layer of an electroluminescent composition comprising a mixture of a substituted or unsubstituted metal quinolate and an electroluminescent organo metallic complex and (iii) a second electrode.

The metal forming the metal quinolate can be selected from sodium, potassium, rubidium, caesium, beryllium, magnesium, calcium, strontium, barium, copper (I), copper (II), silver, gold, zinc, cadmium, boron, aluminium, gallium, indium, germanium, tin (II), tin (IV), antimony (II), antimony (IV), lead (II), lead (IV) and metals of the first, second and third groups of transition metals in different valence states e.g. manganese, iron, ruthenium, osmium, cobalt, nickel, palladium(II), palladium(IV), platinum(II), platinum(IV), cadmium, chromium. titanium, vanadium, zirconium, tantalum, niobium molybdenum, rhodium, iridium, titanium, niobium, scandium, yttrium and the preferred metals are lithium, aluminium, titanium, zirconium, hafnium, vanadium, niobium or tantalum; lithium quinolate is the most preferred metal.

Some metal quinolates are electroluminescent materials and, in particular lithium quinolate is a known electroluminescent material and WO 00/32717 discloses a lithium quinolate which is made by the reaction of n-butyl lithium with 8-hydroxy quinoline in an acetonitrile solvent and which emits light in the blue region of the spectrum.

Provided the light emitting band gap of the electroluminescent organo metallic complex is wider than the band gap of the light emitting excited singlet state of the metal quinolate host material and the light emitting band gap of the electroluminescent organo metallic complex material is within the excited singlet state of the metal quinolate host material the metal quinolate makes no contribution to the colour of the light emitted by the mixture of the electroluminescent organo metallic complex and lithium quinolate.

Preferably the HOMO-LUMO gap of the organo metallic complex is within the HOMO-LUMO gap of the metal quinolate.

One type of preferred organo metallic complexes are the ruthenium, rhodium, palladium, osmium, iridium or platinum iridium complexes and, in particular, iridium complexes :- 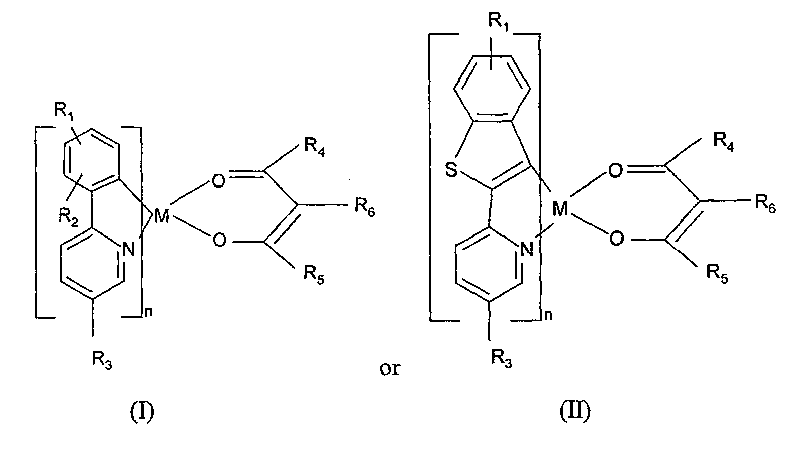 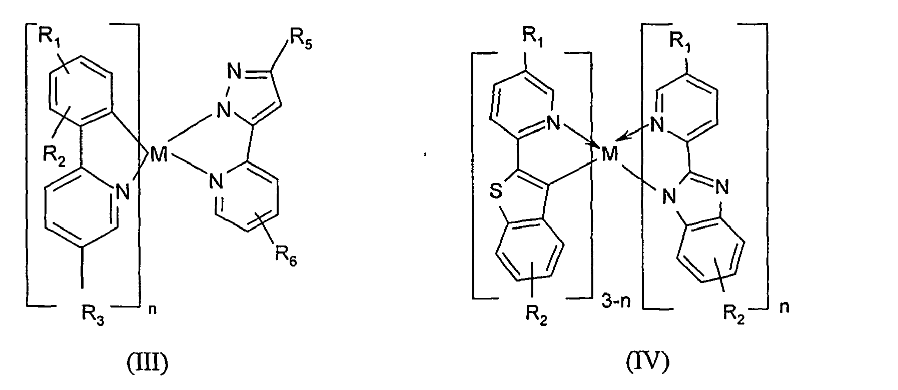 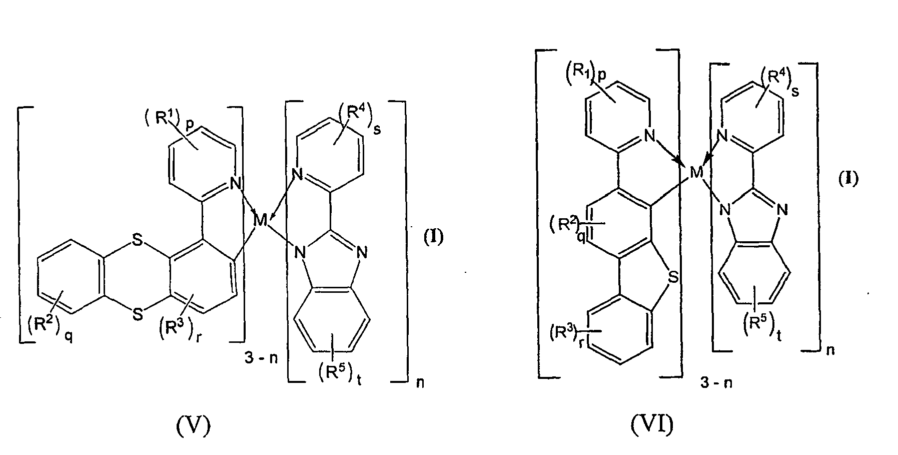 wherein M is ruthenium, rhodium, palladium, osmium, iridium or platinum; n is 1 or 2; R¹ - R⁵ which may be the same or different are selected from substituted and unsubstituted hydrocarbyl groups; substituted and unsubstituted monocyclic and polycyclic heterocyclic groups; substituted and unsubstituted hydrocarbyloxy or carboxy groups; fluorocarbyl groups; halogen; nitrile; nitro; amino; alkylamino; dialkylamino; arylamino; diarylamino; *N-*alkylamido, *N*-arylamido, sulfonyl and thiophenyl; and R² and R³ can additionally be alkylsilyl or arylsilyl; p, s and t independently are 0, 1, 2 or 3; subject to the proviso that where any of p, s and t is 2 or 3 only one of them can be other than saturated hydrocarbyl or halogen; q and r independently are 0, 1 or 2, subject to the proviso that when q or r is 2, only one of them can be other than sanirated hydrocarbyl or halogen R₁, R₂ and R₃ can also form substituted and unsubstituted fused aromatic, heterocyclic and polycyclic ring structures and can be copolymerisable with a monomer, e.g. styrene, and where R₄, and R₅ can be the same or different and are selected from hydrogen, and substituted and unsubstituted hydrocarbyl groups such as substituted and unsubstituted aliphatic groups, substituted and unsubstituted aromatic, heterocyclic and polycyclic ring structures, fluorocarbons such as trifluoryl methyl groups, halogens such as fluorine or thiophenyl groups; R₁, R₂ and R₃ can also form substituted and unsubstituted fused aromatic, heterocyclic and polycyclic ring structures and can be copolymerisable with a monomer, or or R₅ and R₆ form a

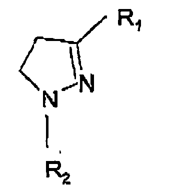

Group and M is ruthenium, rhodium, palladium, osmium, iridium or platinum and n+2 is the valency of M. Preferably M is iridium.

Other preferred organo metallic complexes are of formula M(L)ₙ and MO(L)ₙ₋₂ where M is a metal in a valency state n of greater than 3 and L is an organic ligand, the ligands L can be the same or different, e.g. M(L₁) (L₂) (L₃) (L₄)... or MO(L₁) (L₂)....

Preferably the metal M is a transition metal such as titanium, zirconium or hafnium in the four valency state or vanadium, niobium or tantalum in the five valency state and in particular is zirconium quinolate.

Patent Application WO 2004/058913 discloses doped zirconium quinolates which can be used in the present invention.

Preferably the electroluminescent compound is doped with a minor amount of a fluorescent material as a dopant, preferably in an amount of 5 to 15% of the doped mixture.

As discussed in US 4769292 the presence of the fluorescent material permits a choice from among a wide latitude of wavelengths of light emission.

Useful fluorescent materials are those capable of being blended with the organo metallic complex and fabricated into thin films satisfying the thickness ranges described above forming the luminescent zones of the EL devices of this invention. While crystalline organo metallic complexes do not lend themselves to thin film formation, the limited amounts of fluorescent materials present in the organo metallic complex materials permits the use of fluorescent materials which are alone incapable of thin film formation. Preferred fluorescent materials are those which form a common phase with the organo metallic complex material. Fluorescent dyes constitute a preferred class of fluorescent materials, since dyes lend themselves to molecular level distribution in the organo metallic complex. Although any convenient technique for dispersing the fluorescent dyes in the organo metallic complexes can be undertaken, preferred fluorescent dyes are those which can be vacuum vapour deposited along with the organo metallic complex materials. Assuming other criteria, noted above, are satisfied, fluorescent laser dyes are recognized to be particularly useful fluorescent materials for use in the organic EL devices of this invention. Dopants which can be used include diphenylacridine, coumarins, perylene and their derivatives.

Useful fluorescent dopants are disclosed in US 4769292.

The organometallic complex can be mixed with a dopant and co-deposited with it, preferably by dissolving the dopant and the organometallic complex in the solvent and spin coating the mixed solution.

Other electroluminescent compounds which can be used as the electroluminescent material are of general formula (Lα)ₙM where M is a rare earth, lanthanide or an actinide, Lα is an organic complex and n is the valence state of M.

Further organic electroluminescent compounds which can be used are of formula 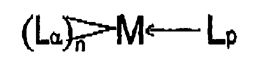 where Lα and Lp are organic ligands, M is a rare earth, transition metal, lanthanide or an actinide and n is the valence state of the metal M. The ligands Lα can be the same or different and there can be a plurality of ligands Lp which can be the same or different.

For example, (L₁)(L₂)(L₃)(L..)M(Lₚ) where M is a rare earth, transition metal, lanthanide or an actinide and (L₁)(L₂)(L₃)(L...) are the same or different organic complexes and (Lₚ) is a neutral ligand, The total charge of the ligands (L₁)(L₂)CL₃)(L..) is equal to the valence state of the metal M. Where there are 3 groups Lα which corresponds to the will valence state of M the complex has the formula (L₁)(L₂)(L₃)M (Lₚ) and the different groups (L₁)(L₂)(L₃) may be the same or different.

Lp can be monodentate, bidentate or polydentate and there can be one or more ligands Lp.

Preferably M is a metal ion having an untilled inner shell and the preferred metals are selected from Sm(III), Eu(II), Eu(III), Tb(III), Dy(III), Yb(III), Lu(III), Gd (III), Gd(III) U(III), Tm(III), Ce (III), Pr(III), Nd(III), Pm(III), Dy(III), Ho(III), Er(III), Yb(III) and more preferably Eu(III), Tb(III), Dy(III), Gd (III), Er (III), Yt(III).

Further organic electroluminescent compounds which can be used are of general formula (Lα)ₙM₁M₂ where M₁ is the same as M above, M₂ is a non rare earth metal, Lα is as above and n is the combined valence state of M₁ and M₂. The complex can also comprise one or more neutral ligands Lp so the complex has the general formula (Lα)ₙ M₁ M₂ (Lₚ), where Lp is as above. The metal M₂ can be any metal which is not a rare earth, transition metal, lanthanide or an actinide. Examples of metals which can be used include lithium, sodium, potassium; rubidium, caesium, beryllium, magnesium, calcium, strontium, barium, copper (I), copper (II), silver, gold, zinc, cadmium, boron, aluminum, gallium, indium, germanium, tin (II), tin (IV), antimony (II), antimony (IV), lead (II), lead (IV) and metals of the first, second and third groups of transition metals in different valence states e.g. manganese, iron, ruthenium, osmium, cobalt, nickel, palladium(II), palladium(IV), platinum(II), platinum(IV), cadmium, chromium. titanium, vanadium, zirconium, tantalum, molybdenum, rhodium, iridium, titanium, niobium, scandium, yttrium.

For example (L₁)(L₂)(L₃)(L..)M (Lp) where M is a rare earth, transition metal, lanthanide or an actinide and (L₁)(L₂)(L₃)(L...) and (Lₚ) are the same or different organic complexes.

Further organometallic complexes which can be used are binuclear, trinuclear and polynuclear organometallic complexes e.g. of formula (Lm)ₓ M₁ ← M₂(Lₙ)_{y} e.g. 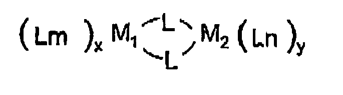 where L is a bridging ligand and where M₁ is a rare earth metal and M₂ is M₁ or a non rare earth metal, Lm and Ln are the same or different organic ligands Lα as defined above, x is the valence state of M₁ and y is the valence state of M₂.

In these complexes there can be a metal to metal bond or there can be one or more bridging ligands between M₁ and M₂ and the groups Lm and Ln can be the same or different.

By trinuclear is meant there are three rare earth metals joined by a metal to metal bond i.e. of formula

(Lm)ₓM₁-M₃(Ln)_{y}-M₂(Lₚ)_{z}

or 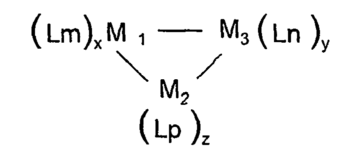 where M₁, M₂ and M₃ are the same or different rare earth metals and Lm, Ln and Lp are organic ligands Lα and x is the valence state of M₁, y is the valence state of M₂ and z is the valence state of M₃. Lp can be the same as Lm and Ln or different.

The rare earth metals and the non rare earth metals can be joined together by a metal to metal bond and/or via an intermediate bridging atom, ligand or molecular group.

For example the metals can be linked by bridging ligands e.g. 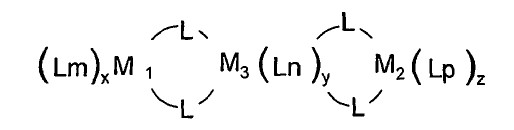 or 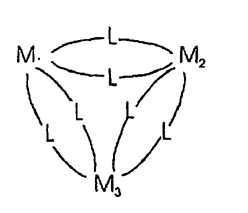 where L is a bridging ligand.

By polynuclear is meant there are more than three metals joined by metal to metal bonds and/or via intermediate ligands

M₁-M₂-M₃-M₄

or

M₁-M₂-M₄-M₃

or 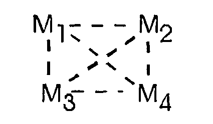 or 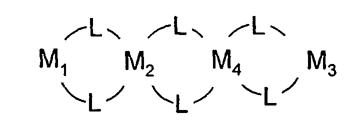 where M₁, M₂, M₃ and M₄ are rare earth metals and L is a bridging ligand.

Preferably Lα is selected from α diketones such as those of formulae 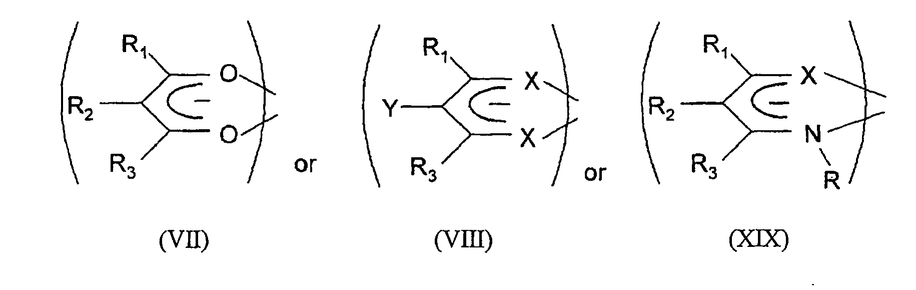 where R₁, R₂ and R₃ can be the same or different and are selected from hydrogen, and substituted and unsubstituted hydrocarbyl groups such as substituted and unsubstituted aliphatic groups, substituted and unsubstituted aromatic, heterocyclic and polycyclic ring structures, fluorocarbons such as trifluoryl methyl groups, halogens such as fluorine or thiophenyl groups; R₁, R₂ and R₃ can also form substituted and unsubstituted fused aromatic, heterocyclic and polycyclic ring structures and can be copolymerisable with a monomer e.g. styrene. X is Se, S or O, Y can be hydrogen, substituted or unsubstituted hydrocarbyl groups, such as substituted and unsubstituted aromatic, heterocyclic and polycyclic ring structures, fluorine, fluorocarbons such as trifluoryl methyl groups, halogens such as fluorine or thiophenyl groups or nitrile.

The beta diketones can be polymer substituted beta diketones and in the polymer, oligomer or dendrimer substituted β diketone the substituents group can be directly linked to the diketone or can be linked through one or more - CH₂ groups i.e. 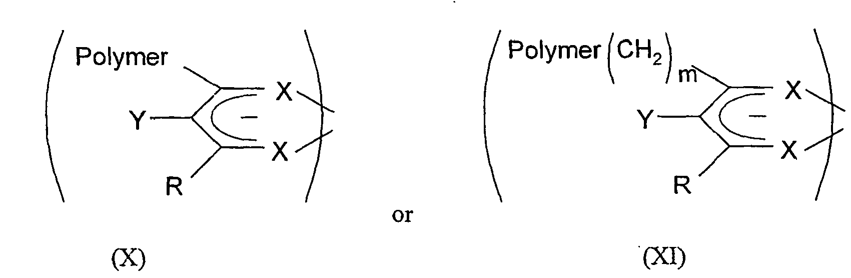 or 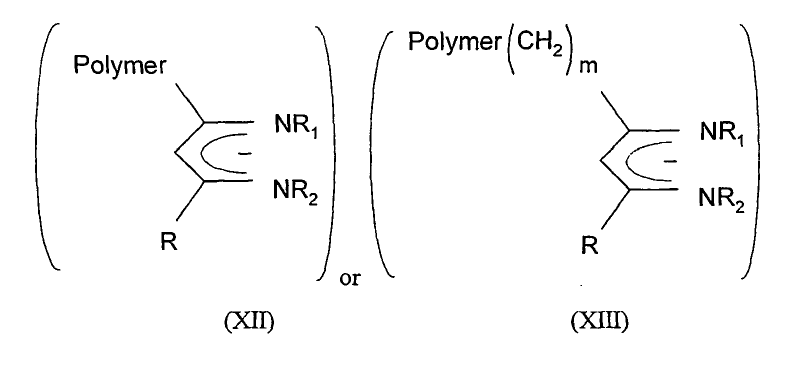 or through phenyl groups e.g. 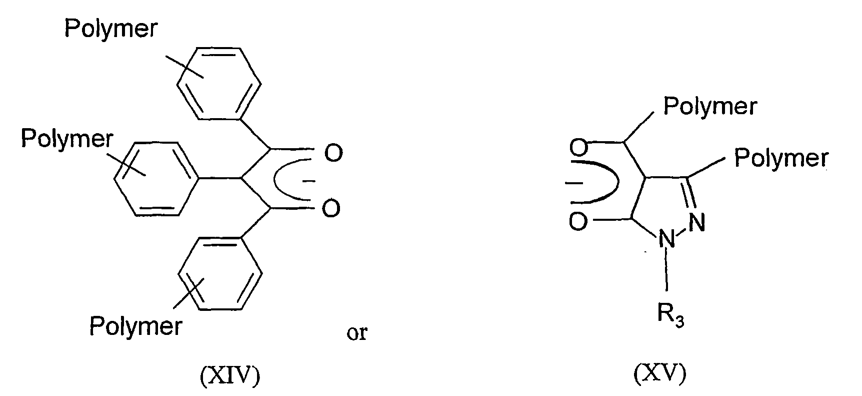 where "polymer" can be a polymer, an oligomer or a dendrimer, (there can be one or two substituted phenyl groups as well as three as shown in (IIIc)) and where R is selected from hydrogen, and substituted and unsubstituted hydrocarbyl groups such as substituted and unsubstituted aliphatic groups, substituted and unsubstituted aromatic, heterocyclic and polycyclic ring structures, fluorocarbons such as trifluoryl methyl groups, halogens such as fluorine or thiophenyl groups.

Examples of R₁ and/or R₂ and/or R₃ include aliphatic, aromatic and heterocyclic alkoxy, aryloxy and carboxy groups, substituted and substituted phenyl, fluorophenyl, biphenyl, phenanthrene, anthracene, naphthyl and fluorene groups alkyl groups such as t-butyl, heterocyclic groups such as carbazole.

Some of the different groups Lα may also be the same or different charged groups such as carboxylate groups so that the group L₁ can be as defined above and the groups L₂, L_{3...} can be charged groups such as 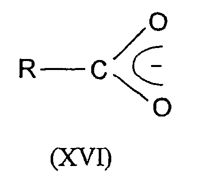 where R is R₁ as defined above or the groups L₁, L₂ can be as defined above and L₃... etc. are other charged groups.
R₁, R₂ and R₃ can also be 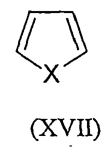 where X is O, S, Se or NH.

A preferred moiety R₁ is trifluoromethyl CF₃ and examples of such diketones are, banzoyltrifluoroacetone, p-chlorobenzoyltrifluoroacetone, p-bromotrifluoroacetone, p-phenyltrifluoroacetone, 1-naphthoyltrifluoroacetone, 2-naphthoyltrifluoroacetone, 2-phenathoyltrifluoroacetone, 3-phenanthoyltrifluoroacetone, 9-anthroyltrifluoroacetonetrifluoroacetone, cinnamoyltrifluoroacetone, and 2-thenoyltrifluoroacetone.

The different groups Lα may be the same or different ligands of formulae 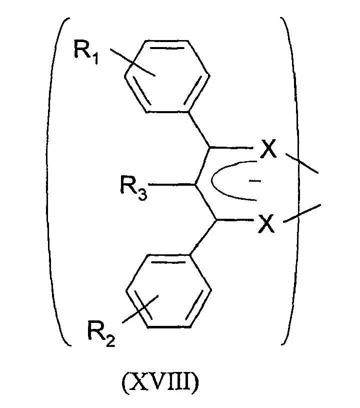 where X is O, S, or Se and R₁ R₂ and R₃ are as above.

The different groups Lα may be the same or different quinolate derivatives such as 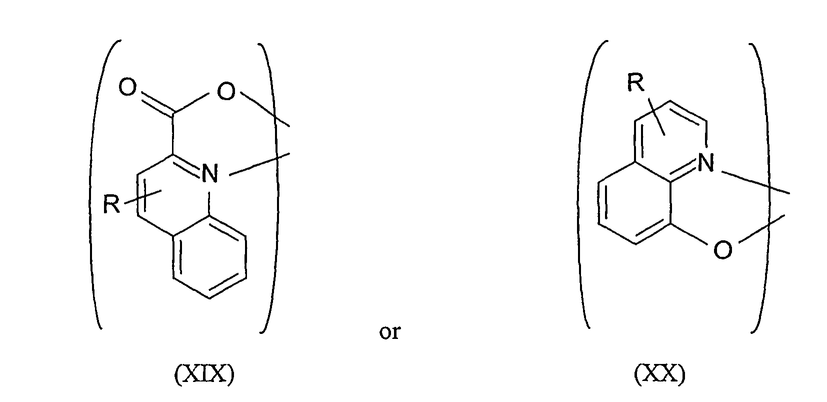 where R is hydrocarbyl, aliphatic, aromatic or heterocyclic carboxy, aryloxy, hydroxy or alkoxy e.g. the 8 hydroxy quinolate derivatives or 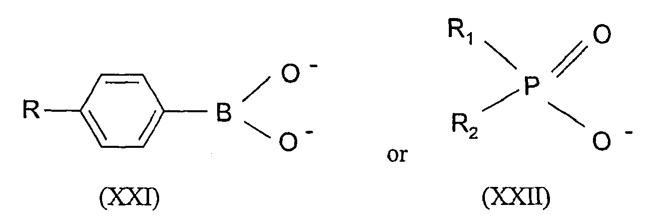 where R, R₁, and R₂ are as above or are H or F e.g. R₁ and R₂ are alkyl or alkoxy groups

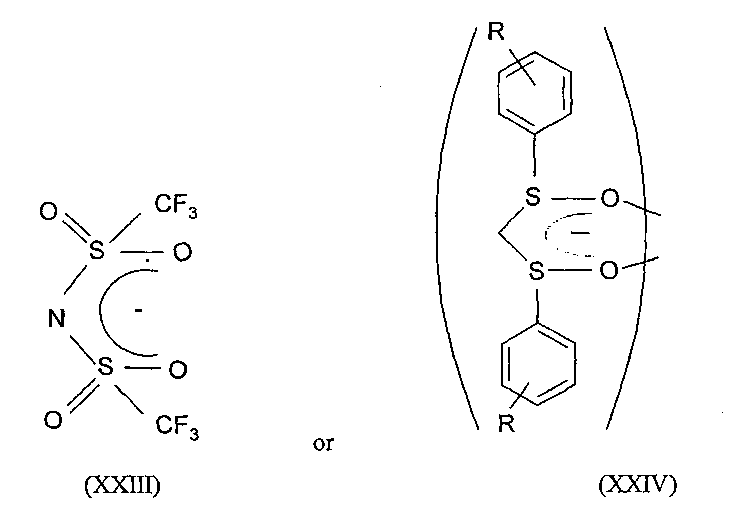

As stated above the different groups Lα may also be the same or different carboxylate groups e.g. 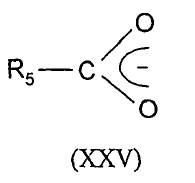 where R₅ is a substituted or unsubstituted aromatic, polycyclic or heterocyclic ring a polypyridyl group, R₅ can also be a 2-ethyl hexyl group so Lₙ is 2-ethylhexanoate or R₅ can be a chair structure so that Lₙ is 2-acetyl cyclohexanoate or Lα can be 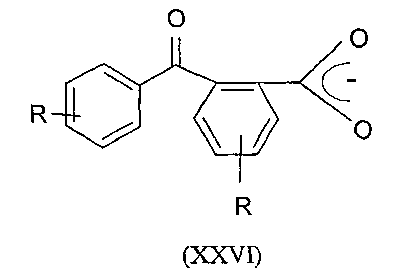 where R is as above e.g. alkyl, allenyl, amino or a fused ring such as a cyclic or polycyclic ring.

The different groups Lα may also be 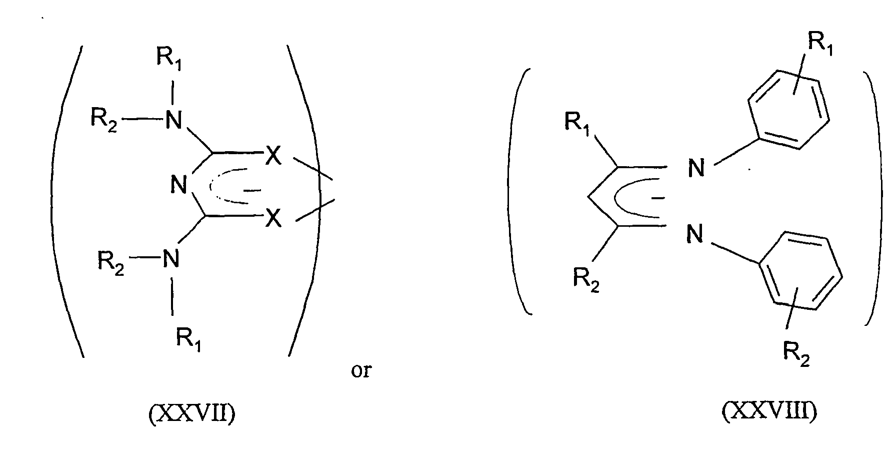 or 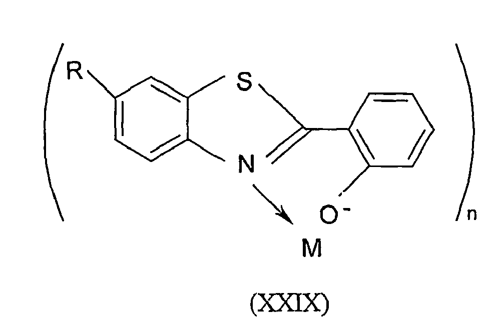 or 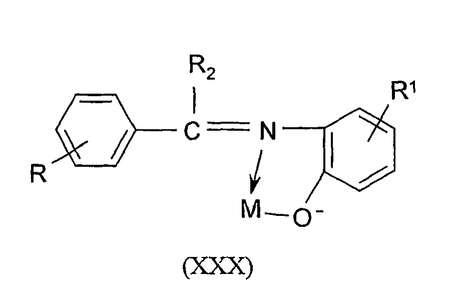 where R, R₁ and R₂ are as above.

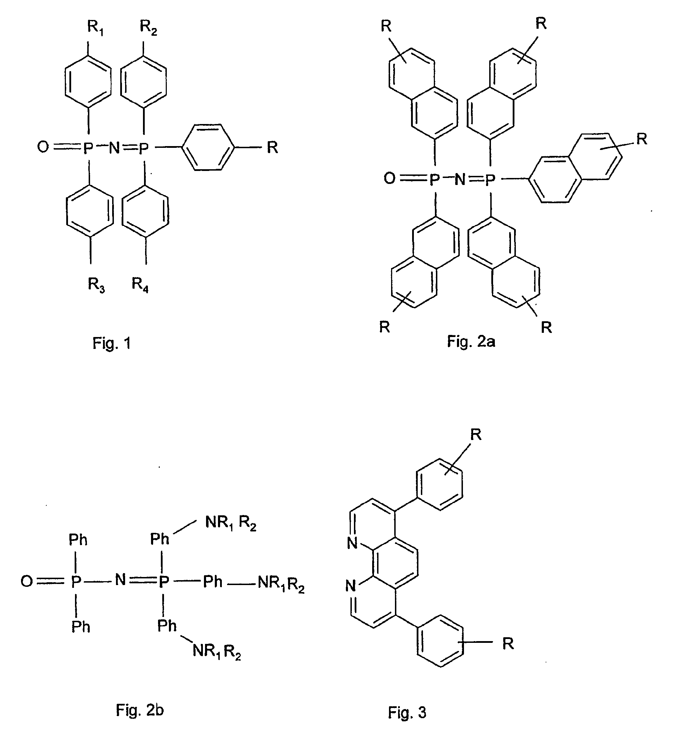

The groups L_{P} can be selected from 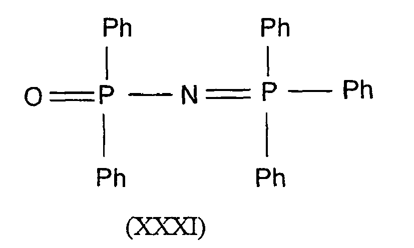 where each Ph which can be the same or different and can be a phenyl (OPNP) or a substituted phenyl group, other substituted or unsubstituted aromatic group, a substituted or unsubstituted heterocyclic or polycyclic group, a substituted or unsubstituted fused aromatic group such as a naphthyl, anthracene, phenanthrene or pyrene group. The substituents can be for example an alkyl, aralkyl, alkoxy, aromatic, heterocyclic, polycyclic group, halogen such as fluorine, cyano, amino, substituted amino etc. Examples are given in figs. 1 and 2 of the drawings where R, R₁, R₂, R₃ and R₄ can be the same or different and are selected from hydrogen, hydrocarbyl groups, substituted and unsubstituted aromatic, heterocyclic and polycyclic ring structures, fluorocarbons such as trifluoryl methyl groups, halogens such as fluorine or thiophenyl groups; R, R₁, R₂, R₃ and R₄ can also form substituted and unsubstituted fused aromatic, heterocyclic and polycyclic ring structures and can be copolymerisable with a monomer e.g. styrene. R, R₁, R₂, R₃ and R₄ can also be unsaturated alkylene groups such as vinyl groups or groups 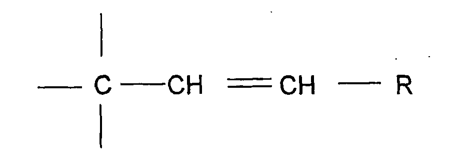 where R is as above.

Lₚ can also be compounds of formulae 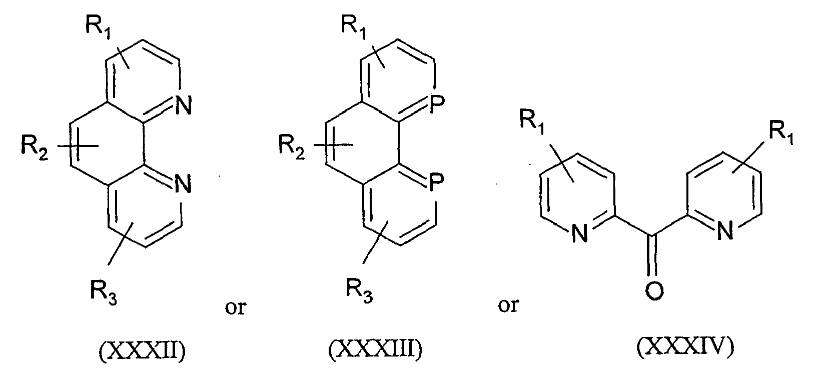 where R₁, R₂ and R₃ are as referred to above, for example bathophen shown in fig. 3 of the drawings in which R is as above or 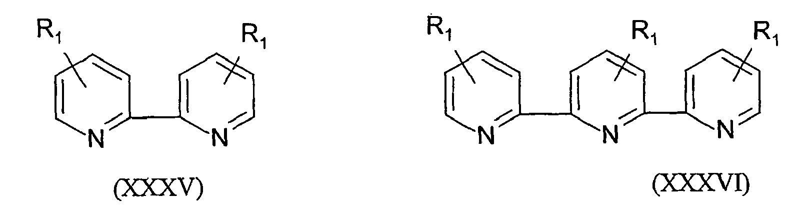 where R₁, R₂ and R₃ are as referred to above.

Lₚ can also be 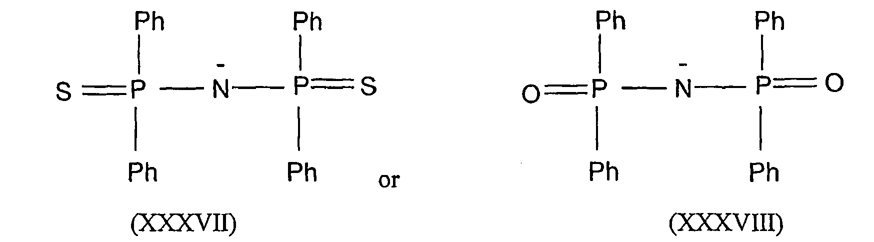 where Ph is as above.

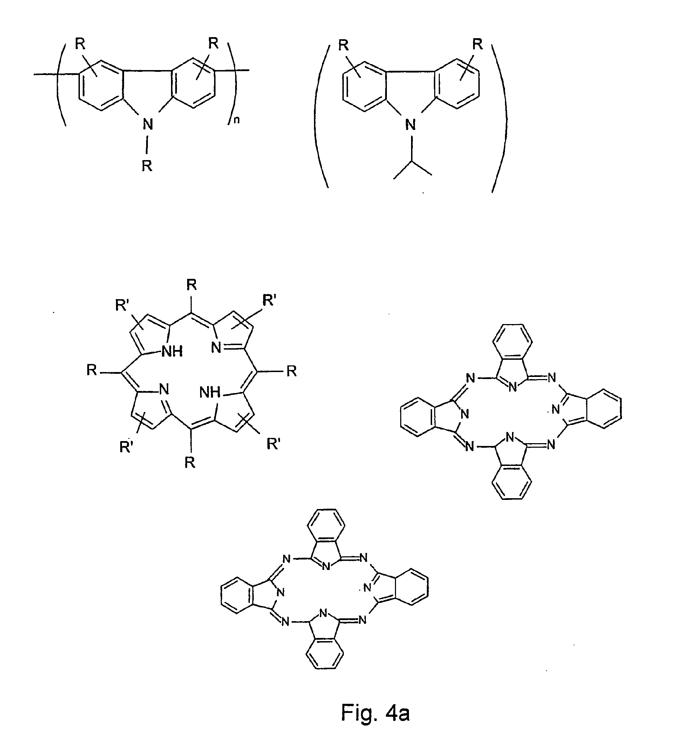

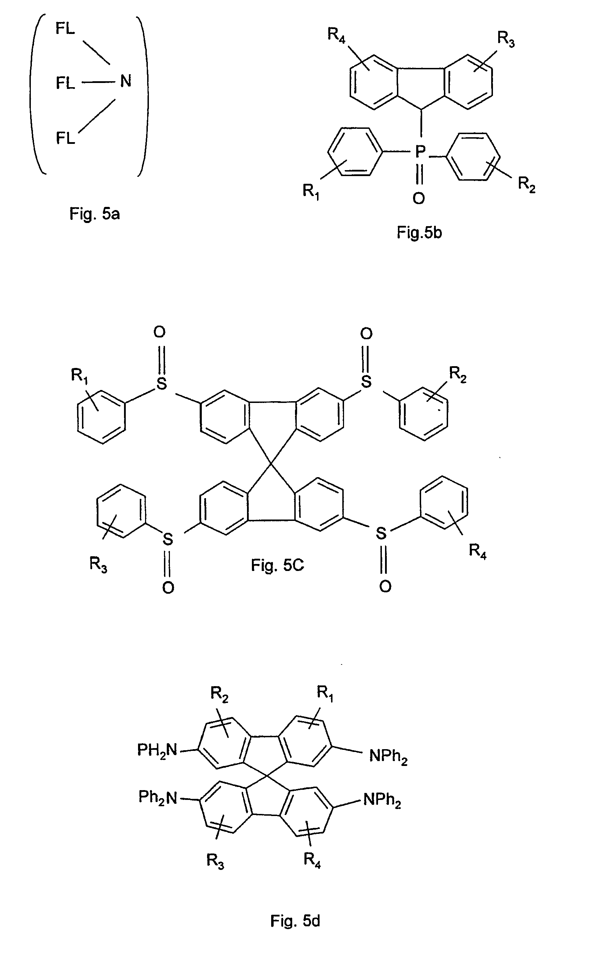

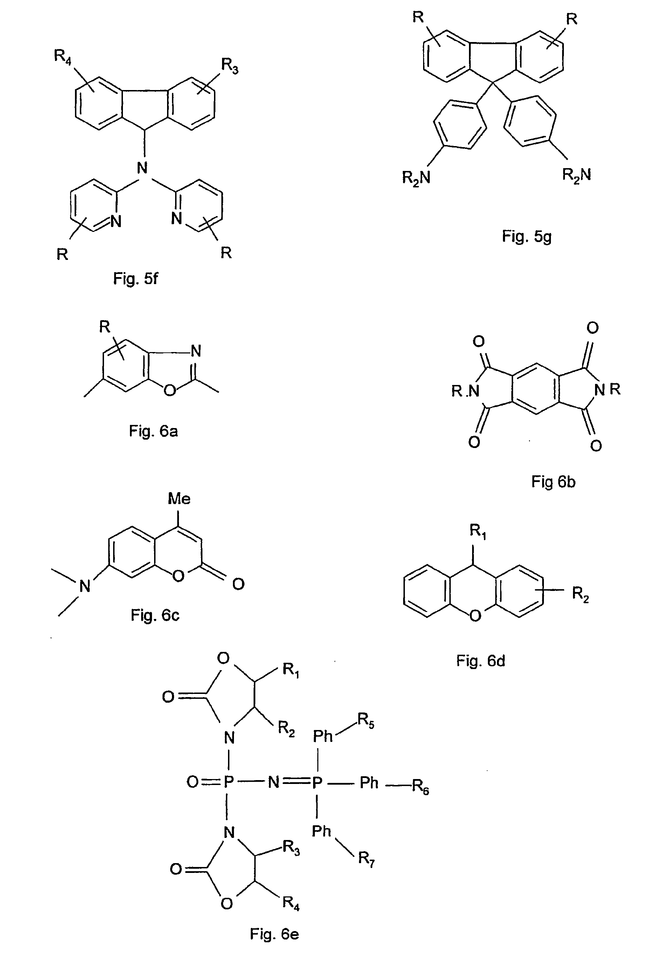

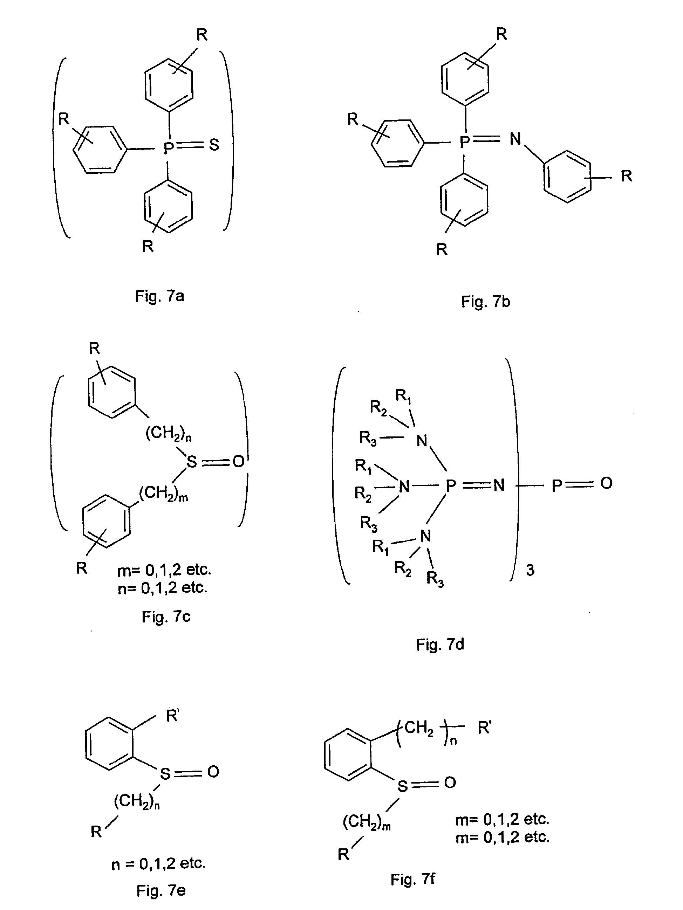

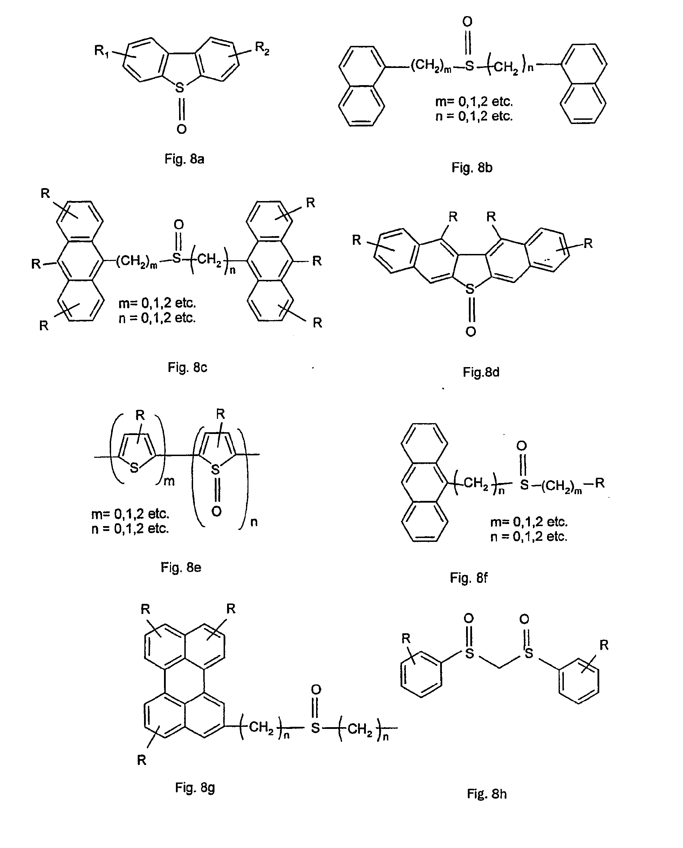

Other examples of Lₚ chelates are as shown in fig. 4 and fluorene and fluorene derivatives e.g. as shown in fig. 5 and compounds of formulae as shown in figs. 6 to 8.

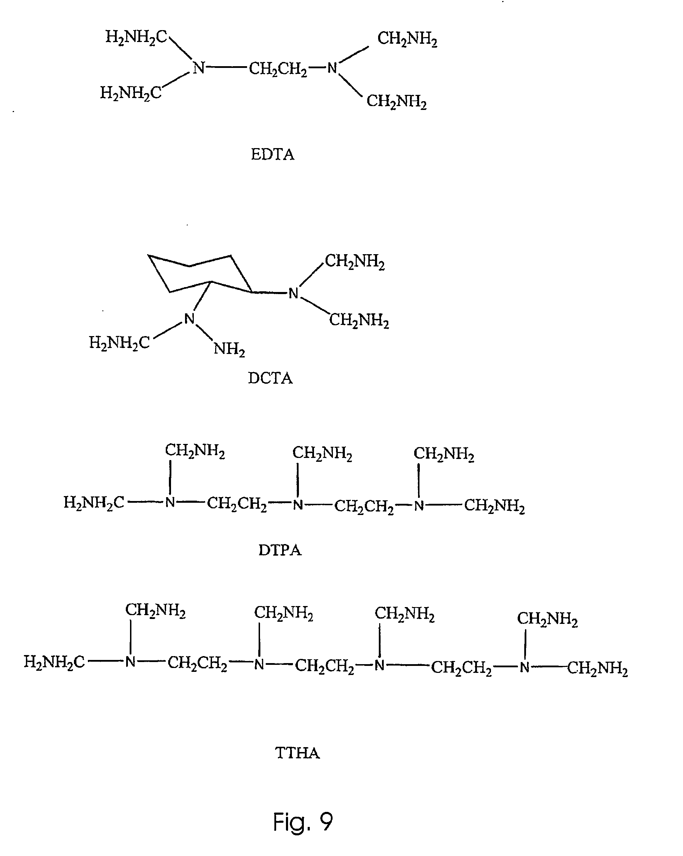

Specific examples of Lα and Lp are tripyridyl and TMHD, and TMHD complexes, α, α', α" tripyridyl, crown ethers, cyclans, cryptans phthalocyanans, porphoryins ethylene diamine tetramine (EDTA), DCTA, DTPA and TTHA, where TMHD is 2,2,6,6-tetramethyl-3,5-heptanedionato and OPNP is diphenylphosphonimide triphenyl phosphorane. The formulae of the polyamines are shown in fig. 9.

Other organic electroluminescent materials which can be used include metal quinolates such as lithium quinolate, and non rare earth metal complexes such as aluminium, magnesium, zinc and scandium complexes such as complexes of p-diketones e.g. Tris -(1,3-diphenyl-1-3-propanedione) (DBM) and suitable metal complexes are Al(DBM)₃, Zn(DBM)₂ and Mg(DBM)_{2.,} Sc(DBM)₃ etc.

Other organic electroluminescent materials which can be used include the metal complexes of formula 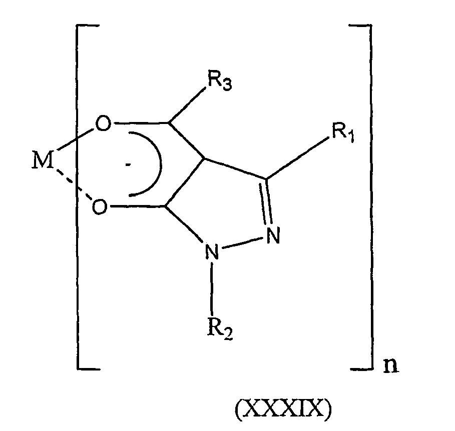 where M is a metal other than a rare earth, a transition metal, a lanthanide or an actinide; n is the valency of M; R₁, R₂ and R₃ which may be the same or different are selected from hydrogen, hydrocarbyl groups, substituted and unsubstituted aliphatic groups substituted and unsubstituted aromatic, heterocyclic and polycyclic ring structures, fluorocarbons such as trifluoryl methyl groups, halogens such as fluorine or thiophenyl groups or nitrile; R₁, and R₃ can also be form ring structures and R₁, R₂ and R₃ can be copolymerisable with a monomer e.g. styrene. Preferably M is aluminium and R₃ is a phenyl or substituted phenyl group.

Other organic electroluminescent materials which can be used include electroluminescent diiridium compounds of formula 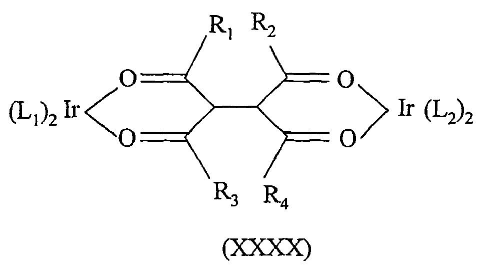 where R_{1,} R_{2,} R₃ and R₄ can be the same or different and are selected from hydrogen, and substituted and unsubstituted hydrocarbyl groups; preferably R_{1,} R_{2,} R₃ and R₄ are selected from substituted and unsubstituted aliphatic groups, substituted and unsubstituted aromatic, heterocyclic and polycyclic ring structures, fluorocarbons such as trifluoryl methyl groups, halogens such as fluorine or thiophenyl groups; R₁, R₂ and R₃ can also form substituted and unsubstituted fused aromatic, heterocyclic and polycyclic ring structures and can be copolymerisable with a monomer and L₁ and L₂ are the same or different organic ligands and more preferably L₁ and L₂ are selected from phenyl pyridine and substituted phenylpryidines.

Other electroluminescent compounds which can be used are of formula 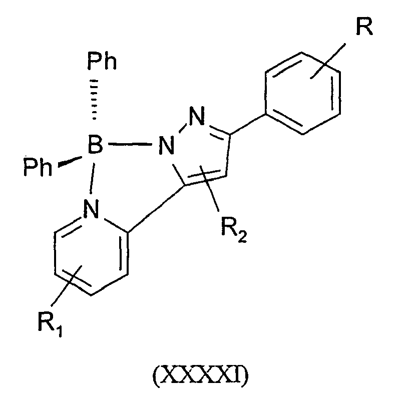 where Ph is an unsubstituted or substituted phenyl group where the substituents can be the same or different and are selected from hydrogen, and substituted and unsubstituted hydrocarbyl groups such as substituted and unsubstituted aliphatic groups, substituted and unsubstituted aromatic, heterocyclic and polycyclic ring structures, fluorocarbons such as trifluoryl methyl groups, halogens such as fluorine or thiophenyl groups; R, R₁ and R₂ can be hydrogen or substituted or unsubstituted hydrocarbyl groups, such as substituted and unsubstituted aromatic, heterocyclic and polycyclic ring structures, fluorine, fluorocarbons such as trifluoryl methyl groups, halogens such as fluorine or thiophenyl groups or nitrile.

Examples of R and/or R₁ and/or R₂ and/or R₃ include aliphatic, aromatic and heterocyclic alkoxy, aryloxy and carboxy groups, substituted and substituted phenyl, fluorophenyl, biphenyl, phenanthrene, anthracene, naphthyl and fluorene groups alkyl groups such as t-butyl, heterocyclic groups such as carbazole.

Further electroluminescent materials which can be used include metal quinolates such as aluminium quinolate, lithium quinolate, zirconium quinolate etc. and metal quinolates doped with fluorescent materials or dies as disclosed in patent application WO/2004/058913.

The metal quinolate host and the electroluminescent material must be different.

The thickness of the layer of the electroluminescent material is preferably from 10 - 250 nm, more preferably 20 - 75 nm.

The first electrode can function as the anode and the second electrode can function as the cathode and preferably there is a layer of a hole transporting material between the anode and the layer of the electroluminescent compound.

The hole transporting material can be any of the hole transporting materials used in electroluminescent devices.

The hole transporting material can be an amine complex such as α-NBP, poly (vinylcarbazole), N, N'-diphenyl-N, N'-bis (3-methylphenyl) -1,1' -biphenyl -4,4'-diamine (TPD), an unsubstituted or substituted polymer of an amino substituted aromatic compound, a polyaniline, substituted polyanilines, polythiophenes, substituted polythiophenes, polysilanes and substituted polysilanes etc. Examples of polyanilines are polymers of: 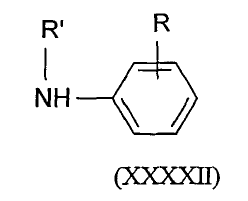 where R is in the ortho- or meta-position and is hydrogen, C1-18 alkyl, C1-6 alkoxy, amino, chloro, bromo, hydroxy or the group: 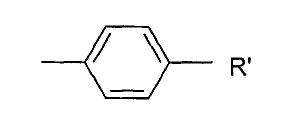 where R is alkyl or aryl and R' is hydrogen, C1-6 alkyl or aryl with at least one other monomer of formula II above.

Alternatively the hole transporting material can be a polyaniline. Polyanilines which can be used in the present invention have the general formula: 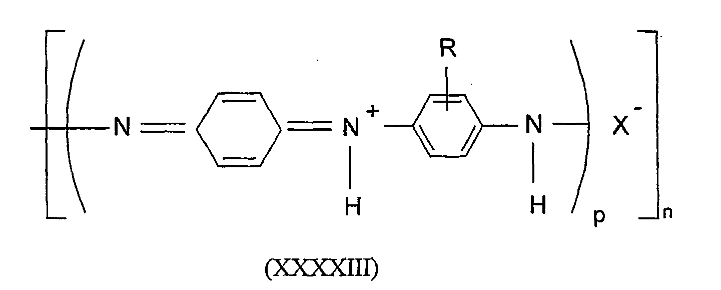 where p is from 1 to 10 and n is from 1 to 20, R is as defined above and X is an anion, preferably selected from Cl, Br, SO₄, BF₄, PF₆, H₂PO₃, H₂PO₄, arylsulphonate, arenedicarboxylate, polystyrenesulphonate, polyacrylate alkylsulphonate, vinylsulphonate, vinylbenzene sulphonate, cellulose sulphonate, camphor sulphonate, cellulose sulphate or a perfluorinated polyanion.

Examples of arylsulphonates are p-toluenesulphonate, benzenesulphonate, 9,10-anthraquinone-sulphonate and anthracenesulphonate. An example of an arenedicarboxylate is phthalate and an example of arenecarboxylate is benzoate.

We have found that protonated polymers of the unsubstituted or substituted polymer of an amino substituted aromatic compound such as a polyaniline are difficult to evaporate or cannot be evaporated. However we have surprisingly found that if the unsubstituted or substituted polymer of an amino substituted aromatic compound is deprotonated, then it can be easily evaporated, i.e. the polymer is evaporable. Preferably evaporable deprotonated polymers of unsubstituted or substituted polymers of an amino substituted aromatic compound are used. The deprotonated unsubstituted or substituted polymer of an amino substituted aromatic compound can be formed by deprotonating the polymer by treatment with an alkali such as ammonium hydroxide or an alkali metal hydroxide such as sodium hydroxide or potassium hydroxide.

The degree of protonation can be controlled by forming a protonated polyaniline and deprotonating. Methods of preparing polyanilines are described in the article by A. G. MacDiarmid and A. F. Epstein, Faraday Discussions, Chem Soc.88 P319, 1989.

The conductivity of the polyaniline is dependent on the degree of protonation with the maximum conductivity being when the degree of protonation is between 40 and 60%, for example about 50%.

Preferably the polymer is substantially fully deprotonated.

A polyaniline can be formed of octamer units. i.e. p is four, e.g.

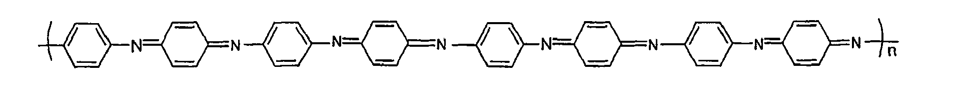

The polyanilines can have conductivities of the order of 1 x 10⁻¹ Siemen cm⁻¹ or higher.

The aromatic rings can be unsubstituted or substituted, e.g. by a C1 to 20 alkyl group such as ethyl.

The polyaniline can be a copolymer of aniline and preferred copolymers are the copolymers of aniline with *o*-anisidine, *m*-sulphanilic acid or *o*-aminophenol, or *o-*toluidine with *o*-aminophenol, *o*-ethylaniline, *o*-phenylene diamine or with amino anthracenes.

Other polymers of an amino substituted aromatic compound which can be used include substituted or unsubstituted polyaminonapthalenes, polyaminoanthracenes, polyaminophenanthrenes, etc. and polymers of any other condensed polyaromatic compound. Polyaminoanthracenes and methods of making them are disclosed in US Patent 6153726. The aromatic rings can be unsubstituted or substituted, e.g. by a group R as defined above.

Other hole transporting materials are conjugated polymers and the conjugated polymers which can be used can be any of the conjugated polymers disclosed or referred to in US 5807627, WO90/13148 and WO92/03490.

The preferred conjugated polymers are poly (p-phenylenevinylene) (PPV) and copolymers including PPV. Other preferred polymers are poly(2,5 dialkoxyphenylene vinylene) such as poly[(2-methoxy-5-(2-methoxypentyloxy-1,4-phenylene vinylene)], poly[(2-methoxypentyloxy)-1,4-phenylenevinylene], poly[(2-methoxy-5-(2-dodecyloxy-1,4-phenylenevinylene)] and other poly(2,5 dialkoxyphenylenevinylenes) with at least one of the alkoxy groups being a long chain solubilising alkoxy group, polyfluorenes and oligofluorenes, polyphenylenes and oligophenylenes, polyanthracenes and oligoanthracenes, polythiophenes and oligothiophenes.

In PPV the phenylene ring may optionally carry one or more substituents, e.g. each independently selected from alkyl, preferably methyl, or alkoxy, preferably methoxy or ethoxy.

In polyfluorene, the fluorene ring may optionally carry one or more substituents e.g. each independently selected from alkyl, preferably methyl, alkoxy, preferably methoxy or ethoxy.

Any poly(arylenevinylene) including substituted derivatives thereof can be used and the phenylene ring in poly(p-phenylenevinylene) may be replaced by a fused ring system such as an anthracene or naphthalene ring and the number of vinylene groups in each poly(phenylenevinylene) moiety can be increased, e.g. up to 7 or higher.

The conjugated polymers can be made by the methods disclosed in US 5807627, WO90/13148 and WO92/03490.

The thickness of the hole transporting layer is preferably 20nm to 200nm.

The polymers of an amino substituted aromatic compound such as polyanilines referred to above can also be used as buffer layers with or in conjunction with other hole transporting materials e.g. between the anode and the hole transporting layer. Other buffer layers can be formed of phthalocyanines such as copper phthalocyanine.

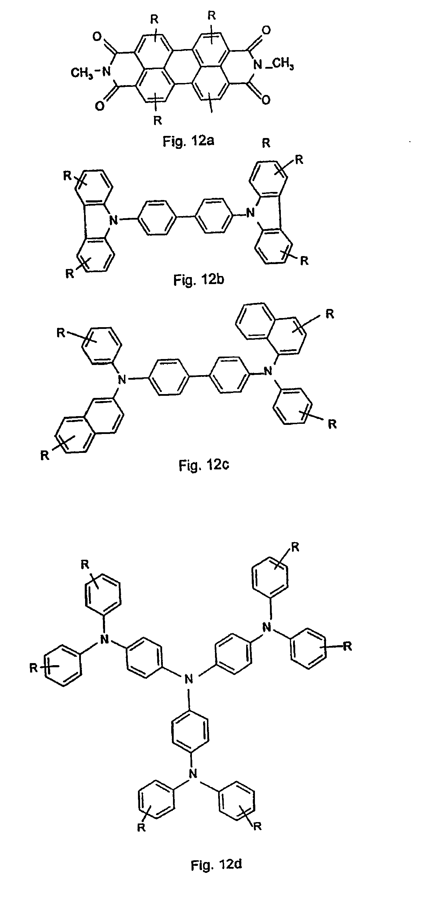

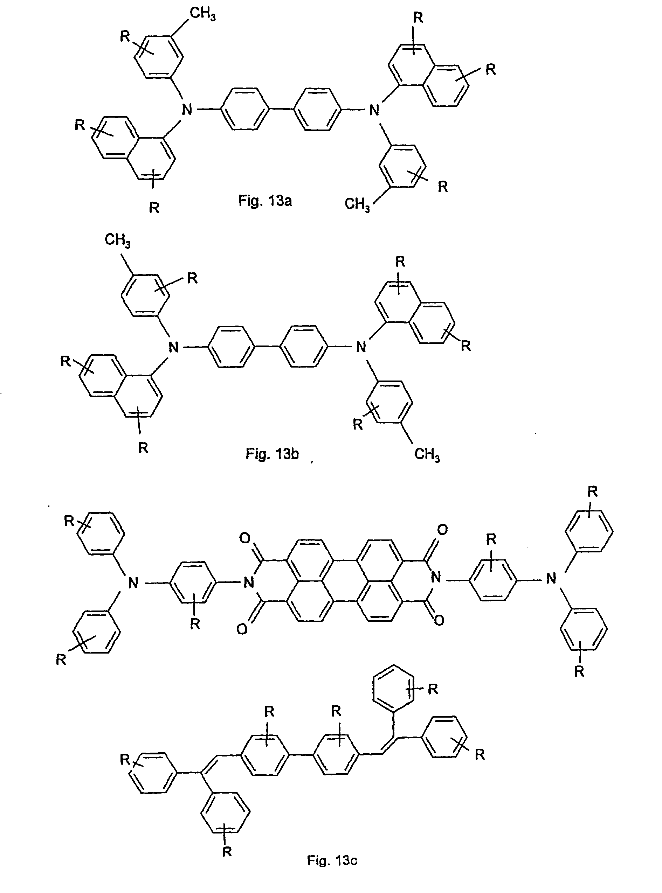

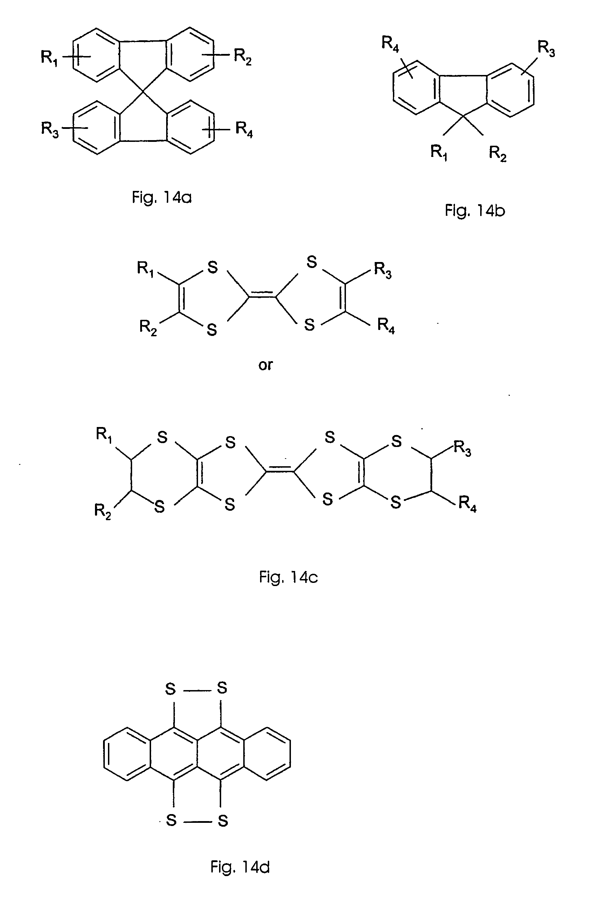

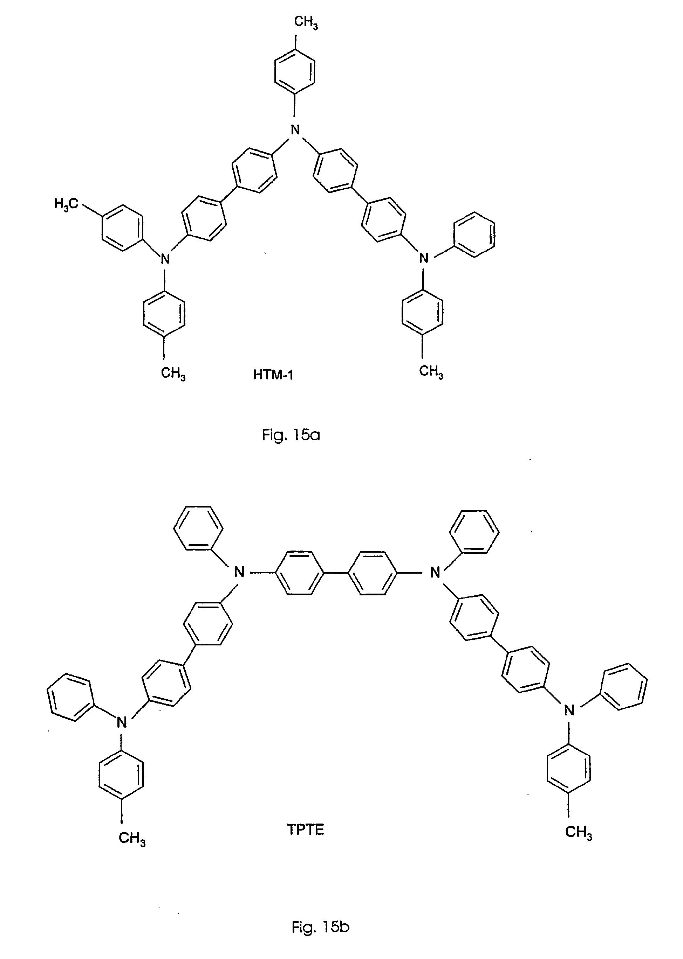

The structural formulae of some other hole transporting materials are shown in Figures 12, 13, 14, 15 and 16 of the drawings, where R, R¹, R², R³ and R⁴ can be the same or different and are selected from hydrogen, substituted and unsubstituted hydrocarbyl groups such as substituted and unsubstituted aliphatic groups, substituted and unsubstituted aromatic, heterocyclic and polycyclic ring structures, fluorocarbon groups such as trifluoromethyl, halogens such as fluorine or thiophenyl groups; R, R¹, R², R³ and R⁴ can also form substituted and unsubstituted fused aromatic, heterocyclic and polycyclic ring structures and can be copolymerisable with a monomer, e.g. styrene. X is Se, S or O, Y can be hydrogen, substituted or unsubstituted hydrocarboxyl groups, such as substituted and unsubstituted aromatic, heterocyclic and polycyclic ring structures, fluorocarbon groups such as trifluoromethyl, halogens such as fluorine, thiophenyl or nitrile groups.

Examples of R and/or R¹ and/or R² and/or R³ and/or R⁴ include aliphatic, aromatic and heterocyclic groups, alkoxy, aryloxy and carboxy groups, substituted and unsubstituted phenyl, fluorophenyl, biphenyl, naphthyl, fluorenyl, anthracenyl and phenanthrenyl groups, alkyl groups such as t-butyl, and heterocyclic groups such as carbazole.

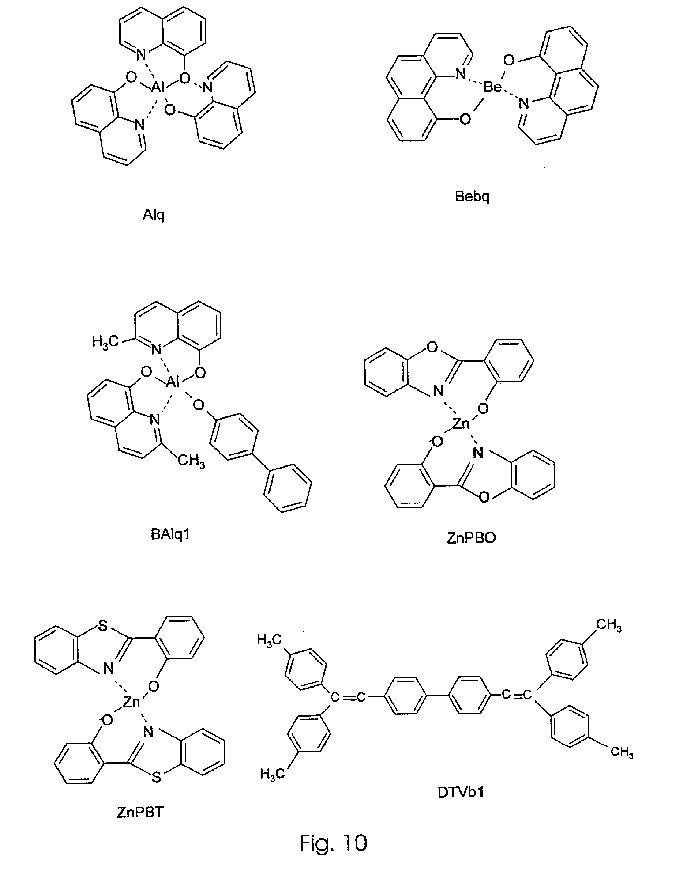

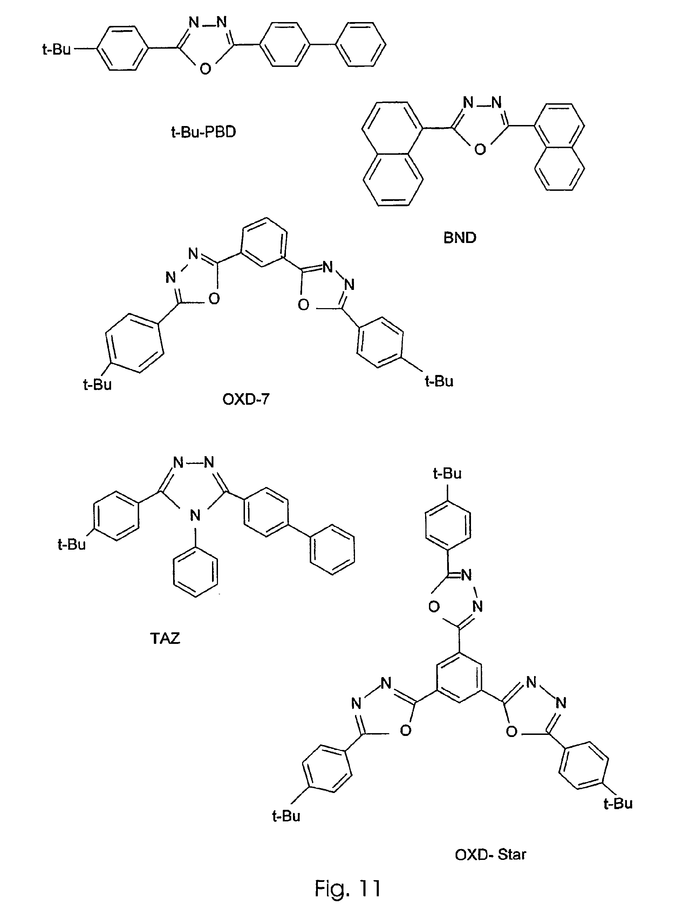

Optionally there is a layer of an electron injecting material between the anode and the electroluminescent material layer. The electron injecting material is a material which will transport electrons when an electric current is passed through. Electron injecting materials include a metal complex such as a metal quinolate, e.g. an aluminium quinolate, lithium quinolate, zirconium quinolate (Zrq₄), a cyanoanthracene such as 9,10dicyanoanthracene, cyano substituted aromatic compounds, tetracyanoquinodimethane, a polystyrene sulphonate or a compound with the structural formulae shown in figures 10 or 11 of the drawings or Mx(DBM)ₙ where Mx is a metal and DBM is dibenzoyl methane and n is the valency of Mx e.g. Mx is aluminium or chromium. A Schiff base can also be used in place of the DBM moiety.

Instead of being a separate layer the electron injecting material can be mixed with the electroluminescent material and co-deposited with it.

Optionally the hole transporting material can be mixed with the electroluminescent material and co-deposited with it and the electron injecting materials and the electroluminescent materials can be mixed. The hole transporting materials, the electroluminescent materials and the electron injecting materials can be mixed together to form one layer, which simplifies the construction.

The first electrode is preferably a transparent substrate such as a conductive glass or plastic material which acts as the anode; preferred substrates are conductive glasses such as indium tin oxide coated glass, but any glass which is conductive or has a conductive layer such as a metal or conductive polymer can be used. Conductive polymers and conductive polymer coated glass or plastics materials can also be used as the substrate.

The cathode is preferably a low work function metal, e.g. aluminium, barium, calcium, lithium, rare earth metals, transition metals, magnesium and alloys thereof such as silver/magnesium alloys, rare earth metal alloys etc; aluminium is a preferred metal. A metal fluoride such as an alkali metal e.g. lithium fluoride or rare earth metal or their alloys can be used as the second electrode, for example by having a metal fluoride layer formed on a metal.

The iridium or other metal complex can be mixed with a host material.

The devices of the present invention can be used as displays in video displays, mobile telephones, portable computers and any other application where an electronically controlled visual image is used. The devices of the present invention can be used in both active and passive applications of such displays.

In known electroluminescent devices either one or both electrodes can be formed of silicon and the electroluminescent material and intervening layers of hole transporting and electron transporting materials can be formed as pixels on the silicon substrate. Preferably each pixel comprises at least one layer of an electroluminescent material and a (at least semi-) transparent electrode in contact with the organic layer on a side thereof remote from the substrate.

Preferably, the substrate is of crystalline silicon and the surface of the substrate may be polished or smoothed to produce a flat surface prior to the deposition of electrode, or electroluminescent compound. Alternatively a non-planarised silicon substrate can be coated with a layer of conducting polymer to provide a smooth, flat surface prior to deposition of further materials.

Each pixel can comprise a metal electrode in contact with the substrate. Depending on the relative work functions of the metal and transparent electrodes, either may serve as the anode with the other constituting the cathode.

When the silicon substrate is the cathode an indium tin oxide coated glass can act as the anode and light is emitted through the anode. When the silicon substrate acts as the anode, the cathode can be formed of a transparent electrode which has a suitable work function; for example by an indium zinc oxide coated glass in which the indium zinc oxide has a low work function. The anode can have a transparent coating of a metal formed on it to give a suitable work function. These devices are sometimes referred to as top emitting devices or back emitting devices.

The metal electrode may consist of a plurality of metal layers; for example a higher work function metal such as aluminium deposited on the substrate and a lower work function metal such as calcium deposited on the higher work function metal. In another example, a further layer of conducting polymer lies on top of a stable metal such as aluminium.

Preferably, the electrode also acts as a mirror behind each pixel and is either deposited on, or sunk into, the planarised surface of the substrate. However, there may alternatively be a light absorbing black layer adjacent to the substrate.

Selective regions of a bottom conducting polymer layer can be made non-conducting by exposure to a suitable aqueous solution allowing formation of arrays of conducting pixel pads which serve as the bottom contacts of the pixel electrodes.

### Device construction

An electroluminescent device was prepared by sequentially depositing layers of the component layers on an ITO coated glass substrate.

To form the device a pre-etched ITO coated glass piece (10 x 10cm²) was used. The device was fabricated by sequentially forming the layers on the ITO, by vacuum evaporation using a Solciet Machine, ULVAC Ltd. Chigacki, Japan; the active area of each pixel was 3mm by 3mm.

The mixed layers were formed by depositing the two materials simultaneously onto the substrate. In the examples compounds X, Y and Z are

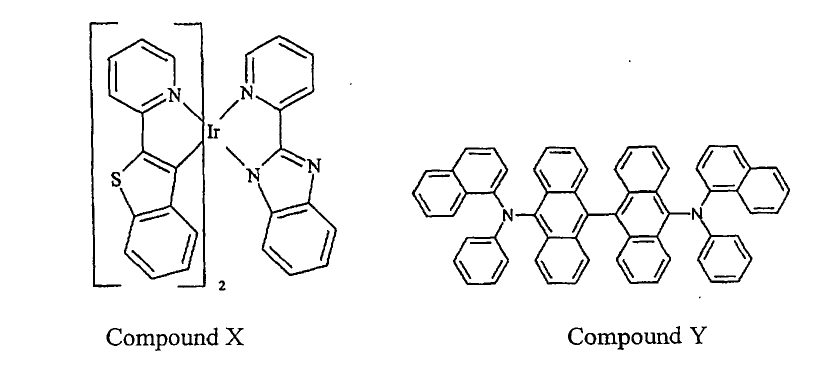

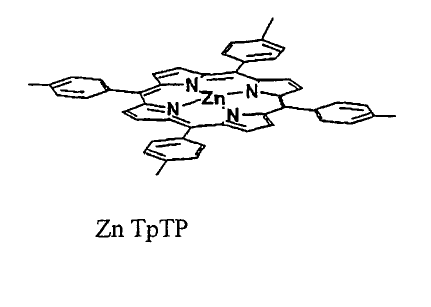

### Example 1

### 2-Benzo[b] thiophen-2-yL-pyridine

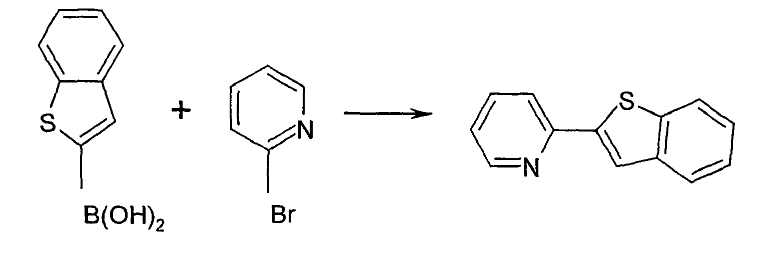

A two-necked 250mL round-bottomed flask fitted with a reflux condenser (with gas inlet) and a rubber septum was flushed with argon before 2-bromopyridine (2.57mL, 27mmol) and ethyleneglycol dimethylether (80mL, dry and degassed) were introduced. Tetrakis(triphenylphosphine) palladium (1.0g, 0.87mmol) was added and the solution stirred at room temperature for 10 minutes. Benzothiophene-2-boronic acid (5.0g, 28.1 mmol) was then added, followed by anhydrous sodium bicarbonate (8.4g. 100mmol) and water (50mL, degassed). The septum was replaced with a glass stopper and the reaction mixture was heated at 80°C for 16 hours, cooled to room temperature and the volatiles removed *in vacuo*. Organics were extracted with ethyl acetate (3 x 100mL), washed with brine and dried over magnesium sulphate. Removal of the organics yielded a pale yellow solid. Recrystallisation from ethanol yielded a colourless solid (3.9g, 68%, two crops), m.p. 124-6°C

### Tetrakis [2-benzo][b]thiophen-2-yl-pyridine-C², N'](µ-chloro) dilridium

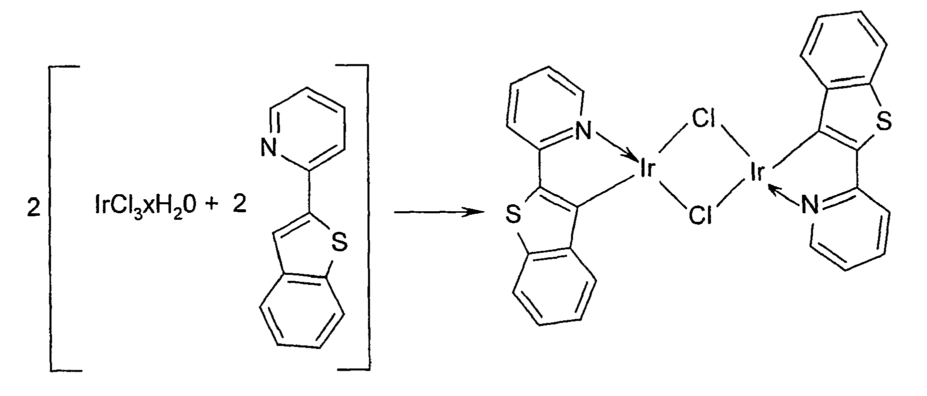

Iridium trichioride hydrate (0.97g, 3.24mmol) was combined with 2-benzo[b]thiophen-2-yl-pyridine (2.05g, 9.7mmol), dissolved in a mixture of 2-ethoxyethanol (70mL, dried and distilled over MgSO₄, degassed) and water (20mL, degassed), and refluxed for 24 hours. The solution was cooled to room temperature and the orange precipitate collected on a glass sinter. The precipitate was washed with ethanol (60mL, 95%), acetone (60mL), and hexane. This was dried and used without further purification. Yield (1.5g. 71 %)

### Bis thiophen-2-yl-pyridine-C², N']-2-(2-pyridyl)benzimidazole iridium

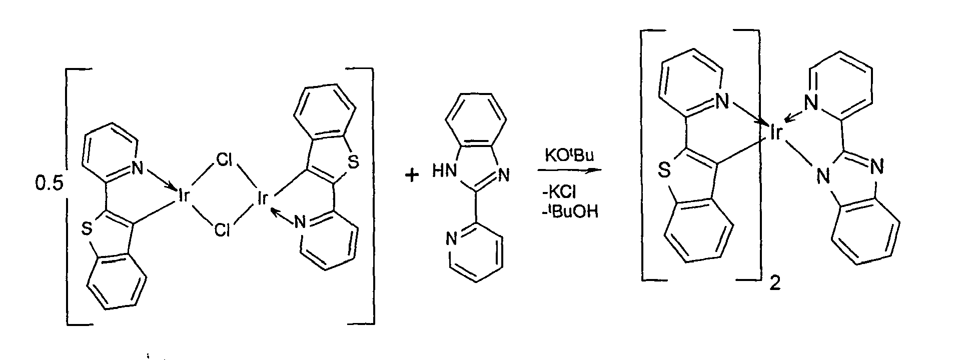

Potassium *tert-butoxide* (1.1 2g, 10 mmol) and 2-(2-pyridyl)benzimidazole (1.95 g, 10mmol) were added to a 200mL Schienk tube under an inert atmosphere. 2-Ethoxyethanol (dried and distilled over magnesium sulphate, 100mL) was added and the resultant solution stirred at ambient temperature for 10 minutes. Tetrakis[2-benzo[b]thiophen-2-yl-pyridine-C², N'](µ-chloro) diiridium (6.0g, 4.62mmol) was added and the mixture refluxed under an inert atmosphere for 16 hours. On cooling to room temperature, an orange/red solid separated out. The solid was collected by filtration and washed with ethanol (3 x 100mL) and diethyl ether (100mL). After drying *in vacuo* the material was purified by soxhlet extraction with ethyl acetate for 24 hours. Further purification was achieved by high-vacuum sublimation (3 x 10⁻⁷ Torr, 400°C). Yield (6.6g, 89%, pre-sublimation)

| Elemental Analysis: | | | | |
|---|---|---|---|---|
| | Calc.: | C, 56.56; | H, 3.00, | N, 8.68 |
| | Found: C, | 56.41; | H, 2.91; | N, 8.64 |

### Example 2

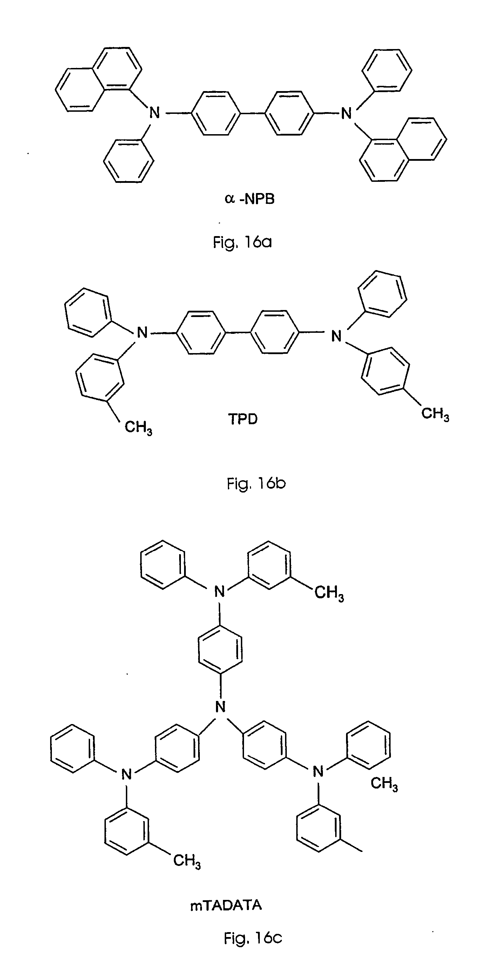

A device was fabricated of structure
ITO(110nm)/CuPc(10nm)/α-NPB(60nm)/Liq:Compound X (30:2)nm /BCP(6nm) / Zrq₄ (30nm)/LiF (0.5nm)/Al
where Compound X is thiophen-2-yl-pyridine-C², N']-2-(2-pyridyl)benzimidazole iridium synthesised as above, CuPc is a copper phthalocyanine buffer layer, α-NPB is as in fig. 16a, Liq is lithium quinolate, BCP is bathocupron, Zrq₄ is zirconium quinolate and LiF is lithium fluoride.

The coated electrodes were stored in a vacuum desiccator over a molecular sieve and phosphorous pentoxide until they were loaded into a vacuum coater Solciet Machine,ULVAC Ltd. Chigacki, Japan; the active area of each pixel was 3mm by 3mm, and aluminium top contacts made. The devices were then kept in a vacuum desiccator until the electroluminescence studies were performed.

The ITO electrode was always connected to the positive terminal. The current vs. voltage studies were carried out on a computer controlled Keithly 2400 source meter.

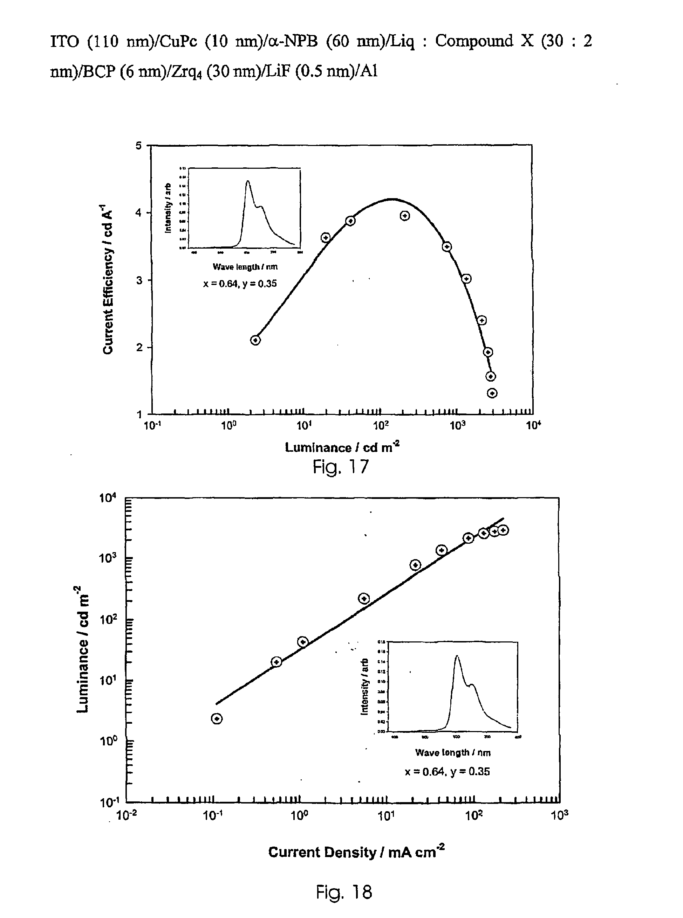

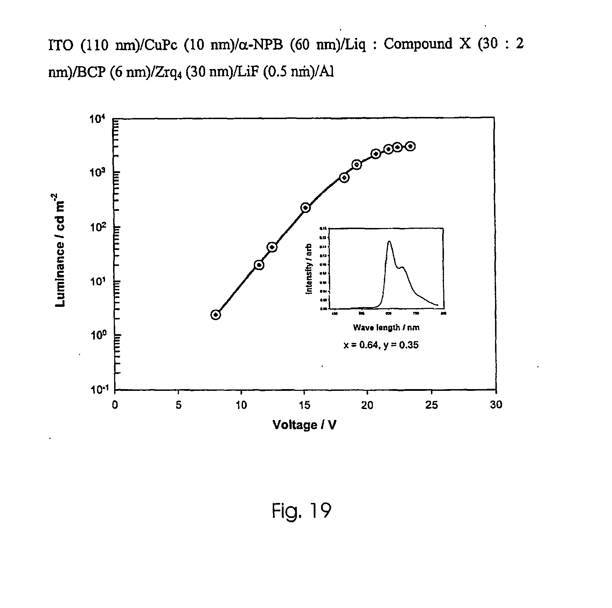

The electroluminescent properties were measured and the results are shown in figs. 17, 18 and 19.

### Comparative Example 3

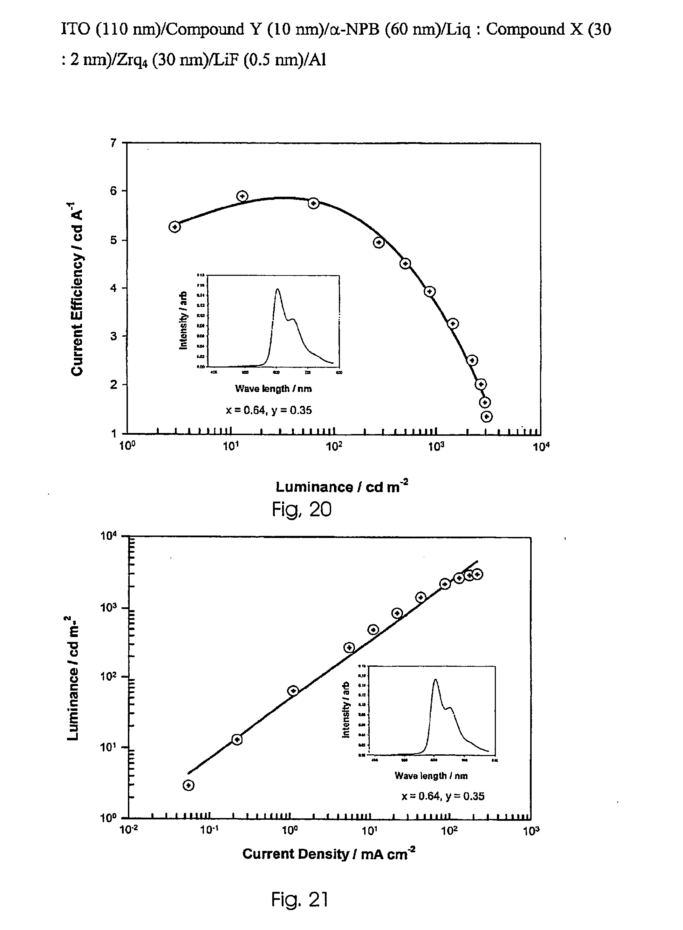

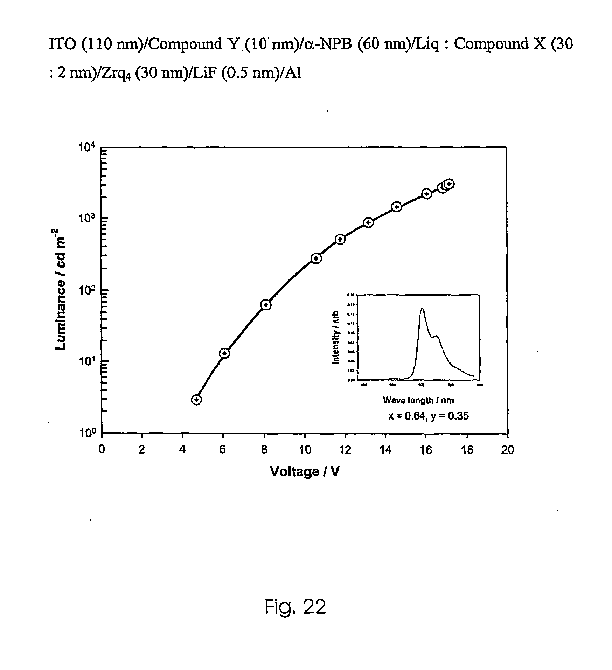

A device was constructed as in Example 2 which had the structure ITO(110nm)/Compound Y(10nm)/α-NPB(60nm)/Liq:Compound X (30:2)nm / Zrq₄ (30nm)/LiF (0.5nm)/Al
An electric current was passed through the device as in Example 2 and the properties of the emitted light measured and the results are shown in figs. 20 to 22 of the drawings.

### Example 4

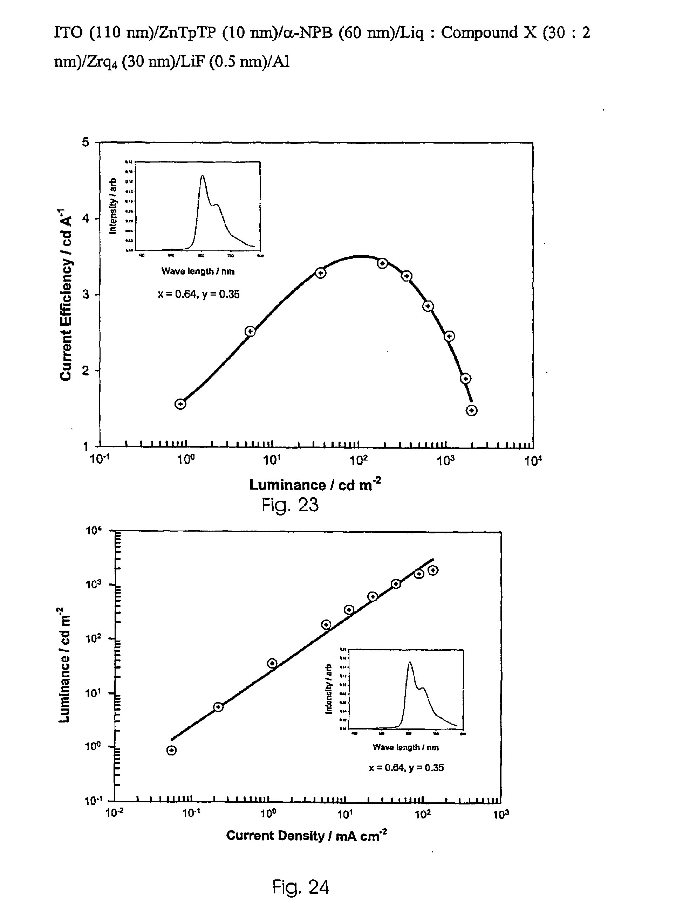

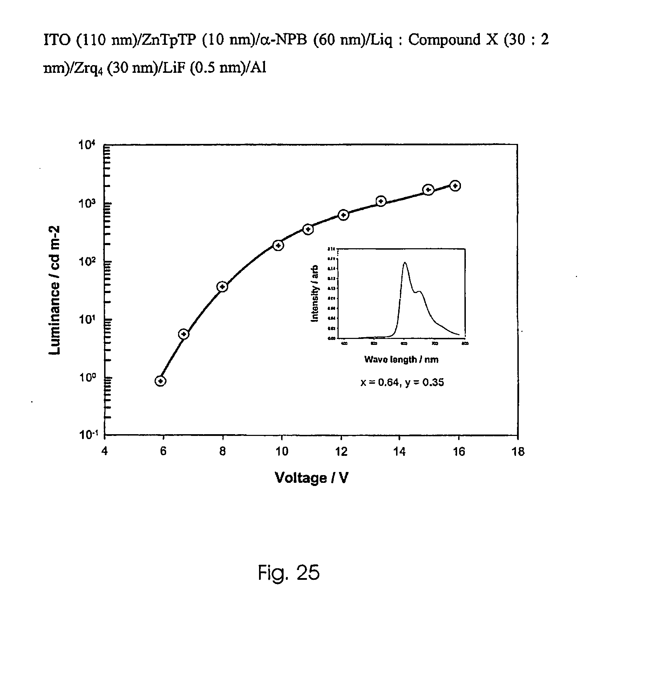

A device was constructed as in Example 2 which had the structure ITO(110nm)/ZnTpTP(10nm)/α-NPB(60nm)/Liq:Compound X (30:2)nm / Zrq₄ (30nm)/LiF (0.5nm)/Al
An electric current was passed through the device as in Example 1 and the properties of the emitted light measured and the results are shown in figs. 23 to 25 of the drawings.

### Example 5

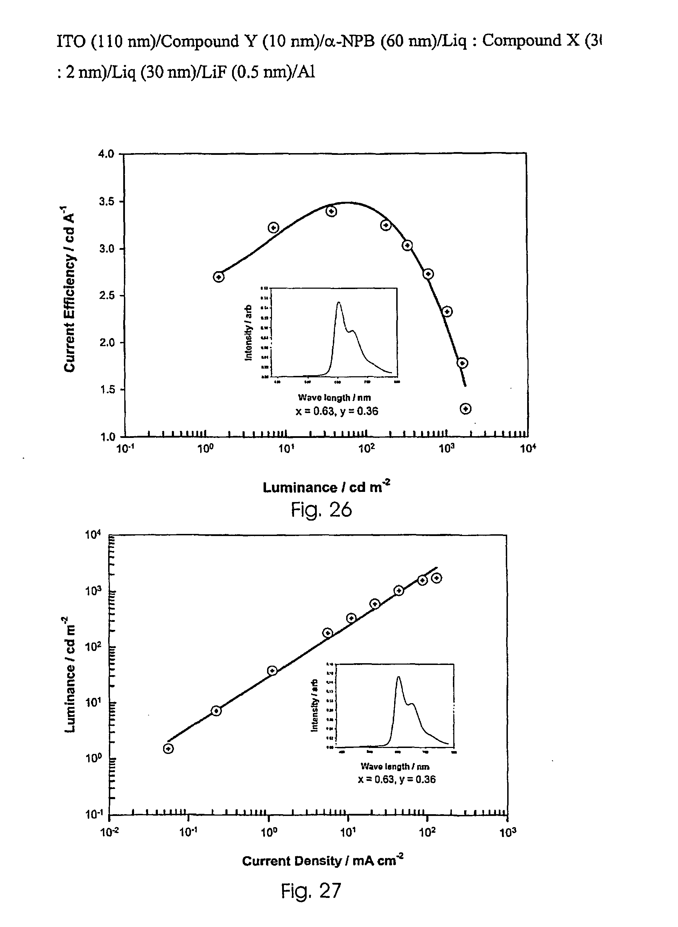

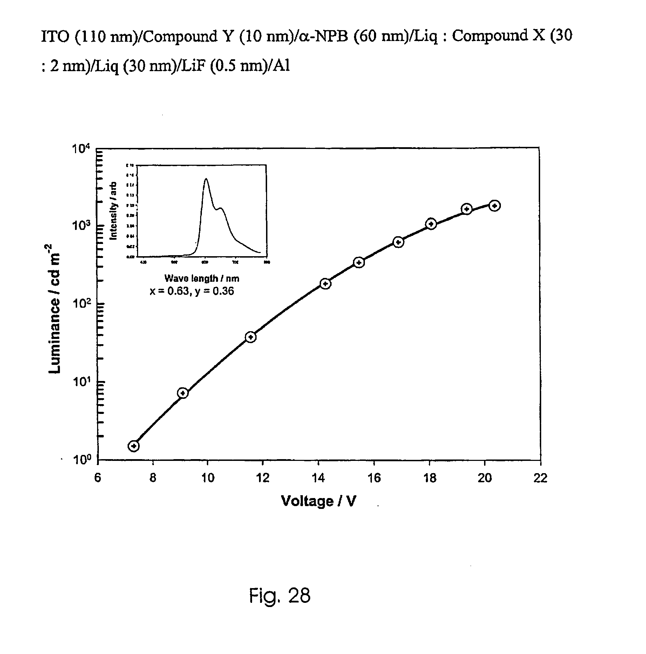

A device was constructed as in Example 2 which had the structure ITO(110nm)/Compound Y(10nm)/α-NPB(60nm)/Liq:Compound X (30:2)nm/ 30nm) /LiF (0.5nm)/Al
An electric current was passed through the device as in Example 1 and the properties of the emitted light measured and the results are shown in figs. 26 to 28 of the drawings.

### Example 6

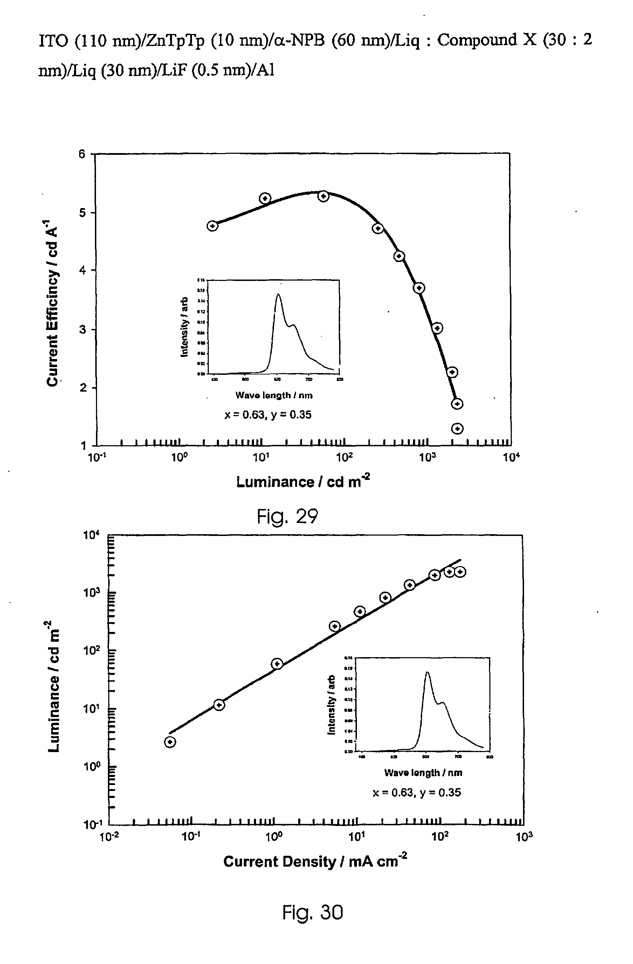

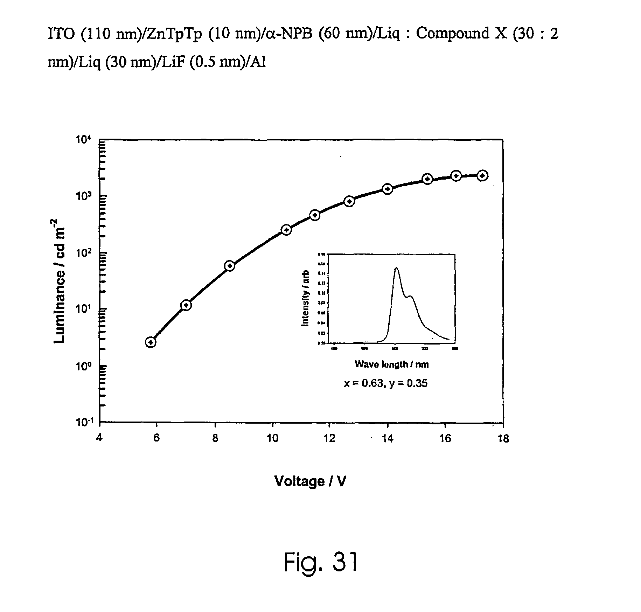

A device was constructed as in Example 2 which had the structure ITO(110nm)/ZnTpTP(10nm)/α-NPB(60nm)/Liq:Compound X (30:2)nm / Liq (30nm)/LiF (0.5nm)/Al
An electric current was passed through the device as in Example 2 and the properties of the emitted light measured and the results are shown in figs. 29 to 31 of the drawings.

## Claims

1. An electroluminescent composition which comprises a mixture of a substituted or unsubstituted metal quinolate and an electroluminescent organometallic complex selected from
(a) a complex of formula 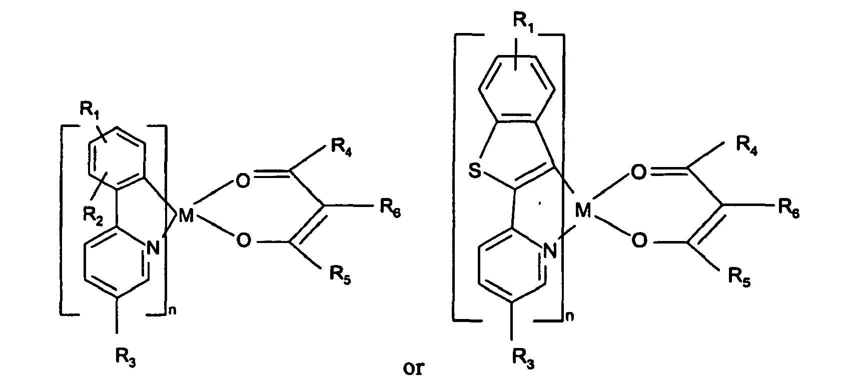 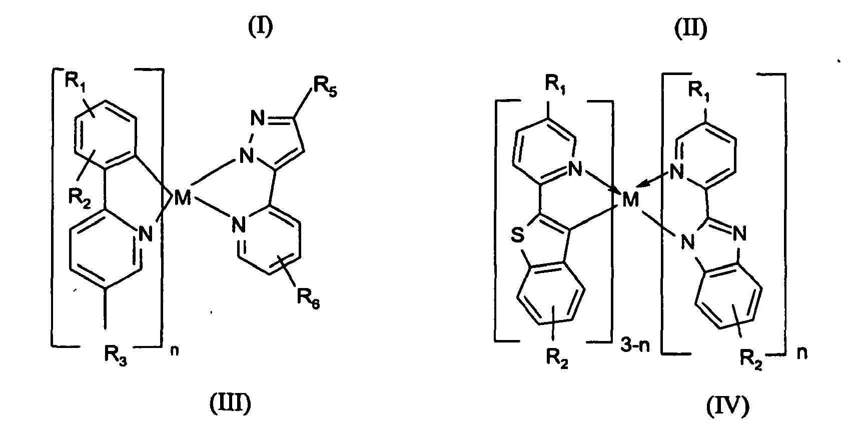 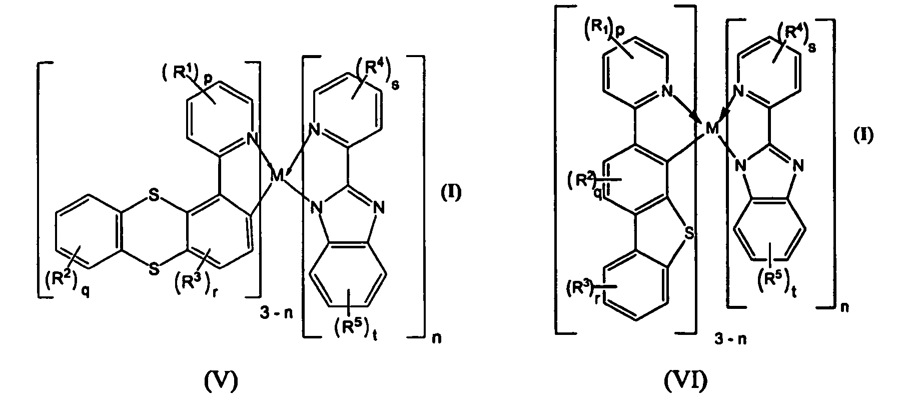 wherein
M is ruthenium, rhodium, palladium, osmium, iridium or platinum;
n is 1 or 2;
R¹ - R⁵ which may be the same or different are selected from substituted and unsubstituted hydrocarbyl groups, substituted and unsubstituted monocyclic and polycyclic heterocyclic groups, substituted and unsubstituted hydrocarbyloxy or carboxy groups, fluorocarbyl groups, halogen, nitrile, nitro, amino, alkylamino, dialkylamino, arylamino, diarylamino, *N*-alkylamido, *N*-arylamido, sulfonyl and thiophenyl and wherein and R² and R³ can additionally be alkylsilyl or arylsilyl;
p, s and t independently are 0, 1, 2 or 3; subject to the proviso that where any of p, s and t is 2 or 3 only one of them can be other than saturated hydrocarbyl or halogen;
q and r independently are 0, 1 or 2, subject to the proviso that when q or r is 2, only one of them can be other than saturated hydrocarbyl or halogen;
(b) a metal complex of formula: 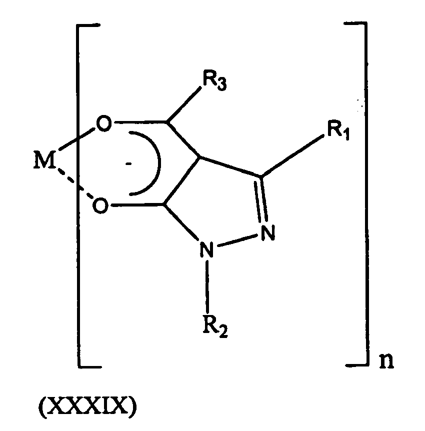 where
M is a metal other than a rare earth, a transition metal, a lanthanide or an actinide;
n is the valence of M;
R₁, R₂ and R₃ which may be the same or different are selected from hydrogen, hydrocarbyl groups, substituted and unsubstituted aliphatic groups substituted and unsubstituted aromatic, heterocyclic and polycyclic ring structures, fluorocarbons, halogens, or thiophenyl groups or nitrile, R₁, and R₃ can also form ring structures and R₁, R₂ and R₃ can be copolymerisable with a monomer;
(c) a diiridium compound of formula 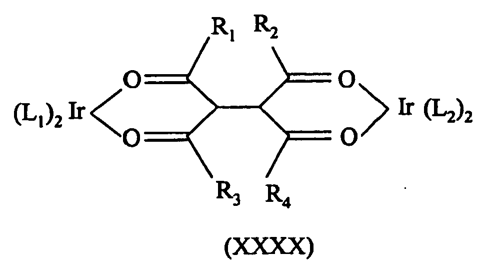 where
R_{1,} R_{2,} R₃ and R₄ can be the same or different and are selected from hydrogen, and substituted and unsubstituted hydrocarbyl groups and can also form substituted and unsubstituted fused aromatic, heterocyclic and polycyclic ring structures and can be copolymerisable with a monomer, and
L₁ and L₂ may be the same or different organic ligands;
(d) a compound of formula 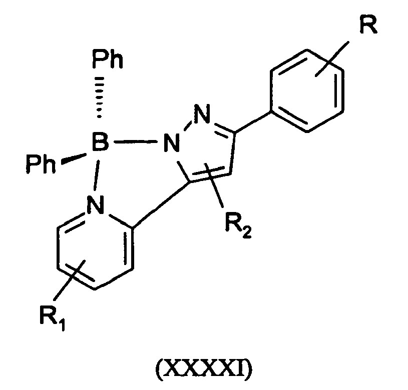 where
Ph is an unsubstituted or substituted phenyl group where the substituents can be the same or different and are selected from hydrogen, and substituted and unsubstituted hydrocarbyl groups;
R, R₁ and R₂ can be hydrogen or substituted or unsubstituted hydrocarbyl groups, fluorine, fluorocarbons, halogen, thiophenyl or nitrile; or

2. The composition of claim 1, wherein the HOMO-LUMO gap of the organometallic complex is within the HOMO-LUMO gap of the metal quinolate.

3. The composition of claim 1 or 2, which comprises substituted or unsubstituted lithium quinolate.

4. The composition of claim 1 or 2, wherein the quinolate is lithium quinolate made by the reaction of n-butyl lithium with 8-hydroxy quinoline in a solvent comprising acetonitrile.

5. An electroluminescent device which comprises (i) a first electrode, (ii) a layer of an electroluminescent composition as claimed in any preceding claim and (iii) a second electrode.

6. The device of claim 5 having any of the following features:
(a) there is a layer of a hole transmitting material between the first electrode and the electroluminescent layer which may comprise a polyaromatic amine or a film of a polymer selected from α-NPB, poly(vinylcarbazole), N,N*-diphenyl-N,N'-bis (3-methylphenyl) -1,1'-biphenyl -4,4'-diamine (TPD), polyaniline, substituted polyanilines, polythiophenes, substituted polythiophenes, polysilanes and substituted polysilanes;
(c) there is a layer of an electron transmitting material between the cathode and the electroluminescent layer; which may comprise aluminium quinolate, zirconium quinolate or lithium quinolate, a material of formula Mx(DBM)ₙ where Mx is a metal and DBM is dibenzoyl methane and n is the valency of Mx, or a cyanoanthracene.

7. The device of claim 5 or 6, having any of the following features:
the first electrode is a transparent electrically conducting glass electrode;
the second electrode is selected from aluminium, barium, rare earth metals, transition metals, calcium, lithium, magnesium and alloys thereof and silver/magnesium alloys;
second electrode is selected from a metal having a metal fluoride layer formed on it; and
the metal fluoride is a lithium fluoride or rare earth fluoride.

## Patentansprüche

1. Elektrolumineszenzzusammensetzung, die ein Gemisch aus einem substituierten oder unsubstituierten Metallchinolat und einem metallorganischen Elektrolumineszenzkomplex ausgewählt aus
(a) einem Komplex der Formel 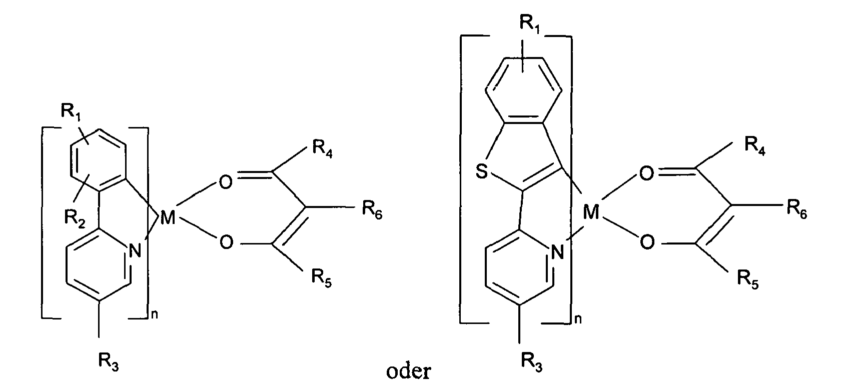 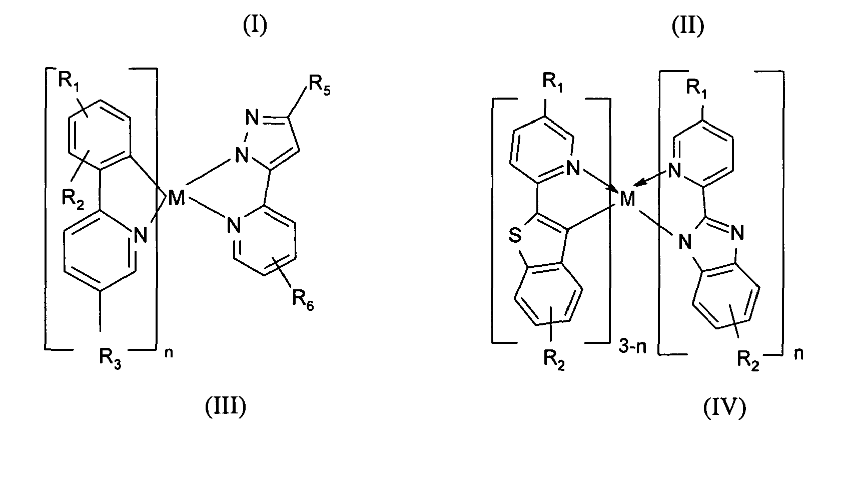 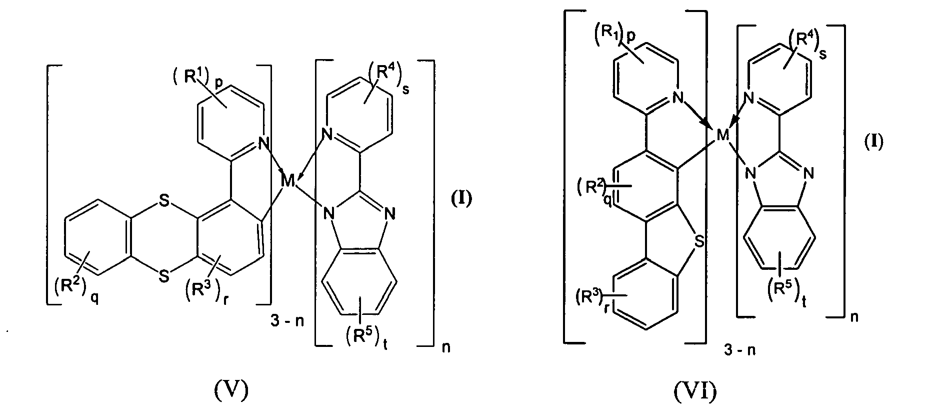 worin
M Ruthenium, Rhodium, Palladium, Osmium, Iridium oder Platin bedeutet;
n für 1 oder 2 steht;
R¹ - R⁵, die gleich oder verschieden sein können, aus substituierten und unsubstituierten Hydrocarbylgruppen, substituierten und unsubstituierten monocyclischen und polycyclischen heterocyclischen Gruppen, substituierten und unsubstituierten Hydrocarbyloxy- oder Carboxygruppen, Fluorcarbylgruppen, Halogen, Nitril, Nitro, Amino, Alkylamino, Dialkylamino, Arylamino, Diarylamino, *N*-Alkylamido, *N*-Arylamido, Sulfonyl und Thiophenyl ausgewählt sind und worin R² und R³ zusätzlich Alkylsilyl oder Arylsilyl bedeuten können;
p, s und t unabhängig für 0, 1, 2 oder 3 stehen; mit der Maßgabe, dass, wenn ein beliebiges von p, s und t für 2 oder 3 steht, nur eines von ihnen etwas anderes als gesättigtes Hydrocarbyl oder Halogen bedeuten kann;
q und r unabhängig für 0, 1 oder 2 stehen, mit der Maßgabe, dass, wenn q oder r für 2 steht, nur eines von ihnen etwas anderes als gesättigtes Hydrocarbyl oder Halogen bedeuten kann;
(b) einem Metallkomplex der Formel: 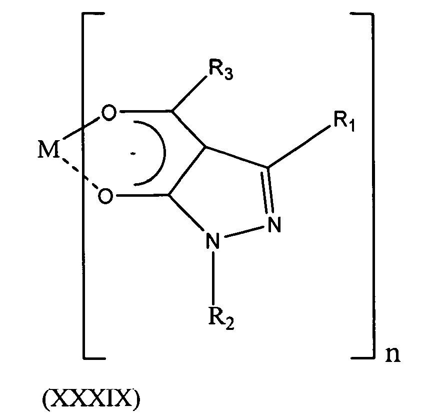 wobei
M ein Metall bedeutet, bei dem es sich nicht um eine seltene Erde, ein Übergangsmetall, ein Lanthanid oder ein Actinid handelt;
n die Wertigkeit von M ist;
R₁, R₂ und R₃, die gleich oder verschieden sein können, aus Wasserstoff, Hydrocarbylgruppen, substituierten und unsubstituierten aliphatischen Gruppen substituierten und unsubstituierten aromatischen, heterocyclischen und polycyclischen Ringstrukturen, Fluorkohlenwasserstoffen, Halogenen oder Thiophenylgruppen oder Nitril ausgewählt sind, R₁ und R₃ auch Ringstrukturen bilden können und R₁, R₂ und R₃ mit einem Monomer copolymerisierbar sein können;
(c) einer Diiridiumverbindung der Formel 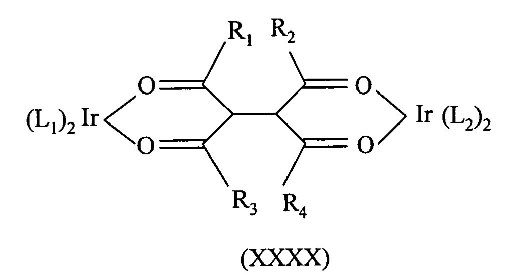 wobei
R₁, R₂, R₃ und R₄ gleich oder verschieden sein können und aus Wasserstoff und substituierten und unsubstituierten Hydrocarbylgruppen ausgewählt sind und auch substituierte und unsubstituierte anellierte aromatische, heterocyclische und polycyclische Ringstrukturen bilden können und mit einem Monomer copolymerisierbar sein können, und
L₁ und L₂ gleiche oder verschiedene organische Liganden bedeuten können;
(d) einer Verbindung der Formel 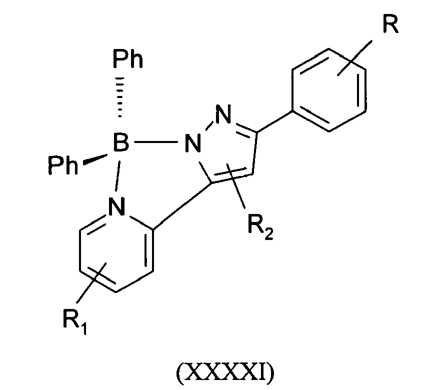 wobei
Ph eine unsubstituierte oder substituierte Phenylgruppe bedeutet, wobei die Substituenten gleich oder verschieden sein können und aus Wasserstoff und substituierten und unsubstituierten Hydrocarbylgruppen ausgewählt sind,
R, R₁ und R₂ Wasserstoff oder substituierte oder unsubstituierte Hydrocarbyl-gruppen, Fluor, Fluorkohlenwasserstoffe, Halogen, Thiophenyl oder Nitril bedeuten können;
enthält.

2. Zusammensetzung nach Anspruch 1, wobei der HOMO-LUMO-Abstand des metallorganischen Komplexes innerhalb des HOMO-LUMO-Abstandes des Metallchinolats liegt.

3. Zusammensetzung nach Anspruch 1 oder 2, die substituiertes oder unsubstituiertes Lithiumchinolat enthält.

4. Zusammensetzung nach Anspruch 1 oder 2, wobei das Chinolat Lithiumchinolat ist, das durch Umsetzung von n-Butyllithium mit 8-Hydroxychinolin in einem Acetonitril-haltigen Lösungsmittel hergestellt wurde.

5. Elektrolumineszenzvorrichtung, die (i) eine erste Elektrode, (ii) eine Schicht einer Elektrolumineszenzzusammensetzung nach einem beliebigen vorhergehenden Anspruch und (iii) eine zweite Elektrode enthält.

6. Vorrichtung nach Anspruch 5 mit beliebigen der folgenden Merkmale:
(a) zwischen der ersten Elektrode und der Elektrolumineszenzschicht befindet sich eine Schicht eines lochübertragenden Materials, das ein polyaromatisches Amin oder einen Film aus einem Polymer ausgewählt aus α-NPB, Poly(vinylcarbazol), N,N'-Diphenyl-N,N'-bis(3-methylphenyl)-1,1'-biphenyl-4,4'-diamin (TPD), Polyanilin, substituierten Polyanilinen, Polythiophenen, substituierten Polythiophenen, Polysilanen und substituierten Polysilanen enthalten kann;
(c) zwischen der Kathode und der Elektrolumineszenzschicht befindet sich eine Schicht eines elektronenübertragenden Materials, das ein Aluminiumchinolat, Zirconiumchinolat oder Lithiumchinolat, ein Material der Formel Mx(DBM)ₙ, wobei Mx ein Metall und DBM Dibenzoylmethan bedeutet und n die Wertigkeit von Mx ist, oder ein Cyanoanthracen enthalten kann.

7. Vorrichtung nach Anspruch 5 oder 6, mit beliebigen der folgenden Merkmale:
die erste Elektrode ist eine transparente elektrisch leitenden Glaselektrode;
die zweite Elektrode ist aus Aluminium, Barium, Seltenerdmetallen, Übergangsmetallen, Calcium, Lithium, Magnesium und deren Legierungen und Silber-Magnesium-Legierungen ausgewählt;
die zweite Elektrode ist aus einem Metall mit einer darauf gebildeten Metallfluoridschicht ausgewählt; und
das Metallfluorid ist ein Lithiumfluorid oder Seltenerdfluorid.

## Revendications

1. Composition électroluminescente qui comprend un mélange d'un quinolate de métal substitué ou non substitué et d'un complexe organométallique électroluminescent choisi parmi
(a) un complexe de formule : 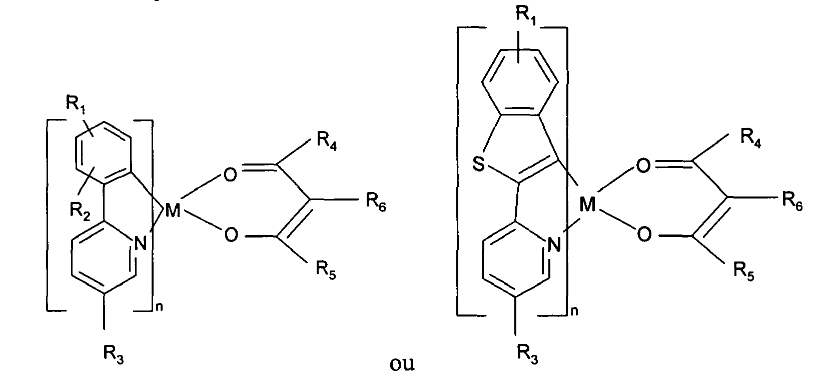 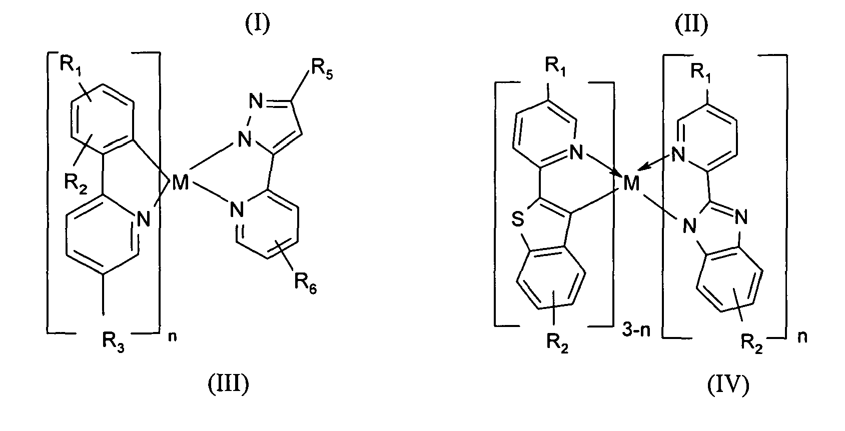 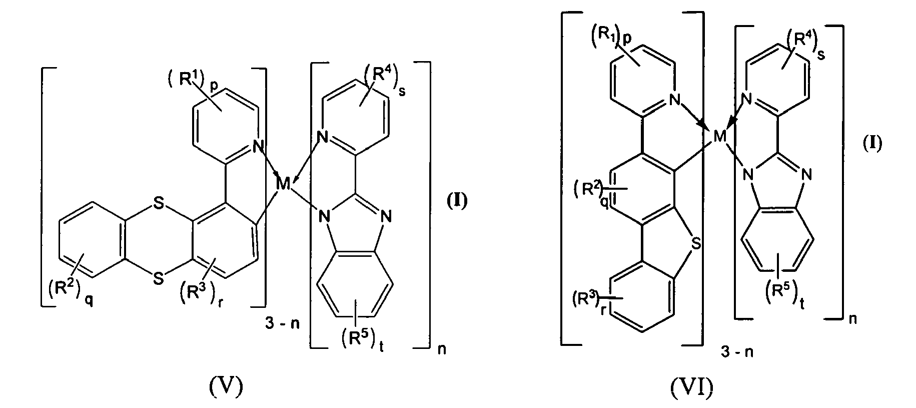 dans laquelle
M est ruthénium, rhodium, palladium, osmium, iridium ou platine ; n est 1 ou 2 ;
R¹ - R⁵, qui peuvent être les mêmes ou différents, sont choisis parmi les groupes hydrocarbyle substitués et non substitués, les groupes hétérocycliques monocycliques et polycycliques substitués et non substitués, les groupes hydrocarbyloxy ou carboxy substitués et non substitués, les groupes fluorocarbyle, halogène, nitrile, nitro, amino, alkylamino, dialkylamino, arylamino, diarylamino, *N*-alkylamido, *N*-arylamido, sulfonyle et thiophényle et dans laquelle R² et R³ peuvent additionnellement être alkylsilyle ou arylsilyle ;
p, s et t, de manière indépendante, sont 0, 1, 2 ou 3 ; étant entendu que lorsque l'un quelconque de p, s et t est 2 ou 3, seulement l'un d'eux peut être autre qu'hydrocarbyle saturé ou halogène;
q et r, de manière indépendante, sont 0, 1 ou 2 ; étant entendu que lorsque q ou r vaut 2, seulement l'un d'eux peut être autre qu'hydrocarbyle saturé ou halogène;
(b) un complexe de métal de formule : 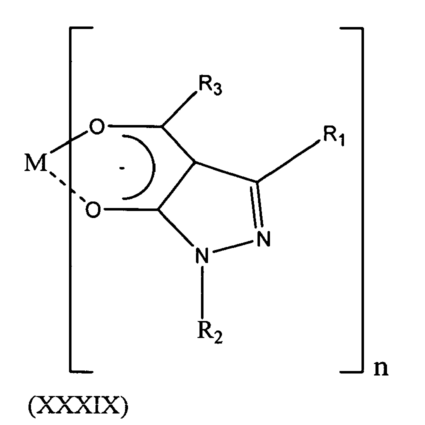 dans laquelle
M est un métal autre qu'une terre rare, un métal de transition, un lanthanide ou un actinide ;
n est la valence de M ;
R₁, R₂ et R₃, qui peuvent être les mêmes ou différents, sont choisis parmi hydrogène, des groupes hydrocarbyle, des groupes aliphatiques substitués et non substitués, des structures cycliques aromatiques, hétérocycliques et polycycliques substituées et non substituées, des fluorocarbones, des halogènes, ou des groupes thiophényle ou nitrile, R₁ et R₃ peuvent également former des structures cycliques et R₁, R₂ et R₃ peuvent être copolymérisables avec un monomère ;
(c) un composé de diiridium de formule : 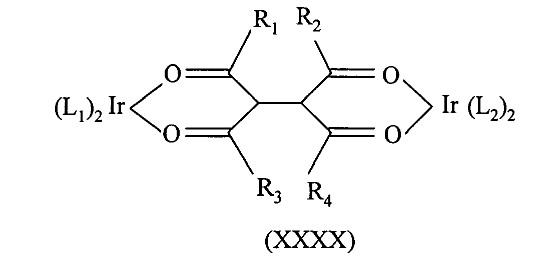 dans laquelle
R₁, R₂, R₃ et R₄ peuvent être les mêmes ou différents et sont choisis parmi hydrogène et des groupes hydrocarbyle substitués et non substitués et peuvent également former des structures cycliques aromatiques, hétérocycliques et polycycliques fusionnées substituées et non substituées et peuvent être copolymérisables avec un monomère ; et
L₁ et L₂ peuvent être les mêmes ligands organiques ou des ligands organiques différents ;
(d) un composé de formule : 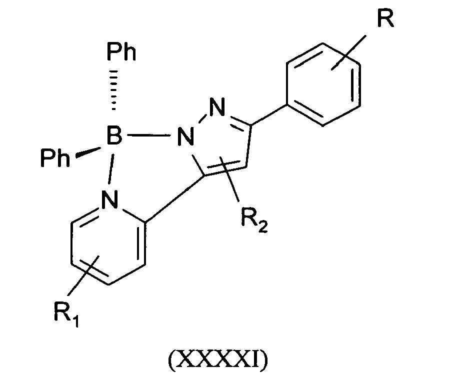 dans laquelle
Ph est un groupe phényle non substitué ou substitué dans lequel les substituants peuvent être les mêmes ou différents et sont choisis parmi hydrogène, et des groupes hydrocarbyle substitués et non substitués ;
R, R₁ et R₂ peuvent être hydrogène ou des groupes hydrocarbyle substitués ou non substitués, fluor, des fluorocarbones, halogène, thiophényle ou nitrile.

2. Composition selon la revendication 1, dans laquelle l'espace HOMO-LUMO du complexe organométallique est à l'intérieur de l'espace HOMO-LUMO du quinolate de métal.

3. Composition selon la revendication 1 ou 2, laquelle comprend du quinolate de lithium substitué ou non substitué.

4. Composition selon la revendication 1 ou 2, dans laquelle le quinolate est du quinolate de lithium fabriqué au moyen de la réaction du lithium n-butyle avec de la quinoléine 8-hydroxy dans un solvant comprenant de l'acétonitrile.

5. Dispositif électroluminescent qui comprend (i) une première électrode, (ii) une couche en une composition électroluminescente telle que revendiquée selon l'une quelconque des revendications précédentes et (iii) une seconde électrode.

6. Dispositif selon la revendication 5, présentant l'une quelconque des caractéristiques qui suivent :
(a) il y a une couche en un matériau émetteur de trous entre la première électrode et la couche électroluminescente, laquelle peut comprendre un amine polyaromatique ou un film en un polymère choisi parmi α-NPB, poly(vinylcarbazole), N,N'-diphényle-N,N'-bis (3-méthylphényle) -1,1'-biphényle -4,4'-diamine (TPD), polyaniline, polyanilines substitués, polythiophènes, polythiophènes substitués, polysilanes et polysilanes substitués ;
(c) il y a une couche en un matériau émetteur d'électrons entre la cathode et la couche électroluminescente, laquelle peut comprendre du quinolate d'aluminium, du quinolate de zirconium ou du quinolate de lithium, un matériau de formule Mx(DBM)n où Mx est un métal et DBM est du méthane dibenzoyle et n est la valence de Mx, ou un cyanoanthracène.

7. Dispositif selon la revendication 5 ou 6, présentant l'une quelconque des caractéristiques qui suivent :
la première électrode est une électrode en verre électriquement conducteur transparent ;
la seconde électrode est choisie parmi aluminium, baryum, métaux des terres rares, métaux de transition, calcium, lithium, magnésium et des alliages afférents et alliages d'argent/de magnésium ;
la seconde électrode est choisie parmi un métal comportant une couche en fluorure de métal formée dessus ; et
le fluorure de métal est un fluorure de lithium ou un fluorure des terres rares.
